(19) Europäisches Patentamt
European Patent Office
Office européen des brevets

(11) **EP 4 125 128 A1**

(12) **EUROPEAN PATENT APPLICATION**

(43) Date of publication:
**01.02.2023 Bulletin 2023/05**

(51) International Patent Classification (IPC):
**H01L 25/075** (2006.01)   **H01L 33/50** (2010.01)
**H01L 33/58** (2010.01)   H01L 27/32 (2006.01)

(21) Application number: **22187251.8**

(22) Date of filing: **27.07.2022**

(52) Cooperative Patent Classification (CPC):
H01L 27/322; **H01L 25/0753; H01L 33/502;**
**H01L 33/507; H01L 33/58;** H01L 2251/5369;
H01L 2933/0091

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.07.2021 KR 20210098499**

(71) Applicant: **Samsung Electronics Co., Ltd.**
**Gyeonggi-do, 16677 (KR)**

(72) Inventors:
• **KIM, Yong Wook**
**Yongin-si (KR)**
• **JANG, Eun Joo**
**Suwon-si (KR)**
• **KWON, Soo Kyung**
**Suwon-si (KR)**
• **KIM, Seon-Yeong**
**Suwon-si (KR)**
• **KIM, Ji-Yeong**
**Suwon-si (KR)**
• **HWANG, Sungwoo**
**Suwon-si (KR)**

(74) Representative: **Elkington and Fife LLP**
**Prospect House**
**8 Pembroke Road**
**Sevenoaks, Kent TN13 1XR (GB)**

(54) **DISPLAY PANEL AND ELECTRONIC DEVICE INCLUDING THE SAME**

(57)     A display panel includes a light emitting panel including a light emitting unit; and a color conversion panel. The color conversion panel includes a color conversion layer including a color conversion region including semiconductor nanoparticles, and a partition wall defining the color conversion region. An optical diffuser is between the light emitting unit and the color conversion region to cover a light extraction surface of the light emitting unit. A length of the light extraction surface of the light emitting unit is greater than or equal to about 500 nm and less than or equal to about 100 μm and a ratio of a length of the optical diffuser to the length of the light extraction surface of the light emitting unit is greater than or equal to about 1.4:1 and less than or equal to about 60:1.

FIG. 1B

**Description**

BACKGROUND

A display panel and an electronic device including the display panel are disclosed.

A display panel may be included in a wide variety of electronic devices. Nanostructures or semiconductor nanoparticles (e.g., quantum dots) may find their applicability in a display panel as a light emitting material and an electronic device including the display panels, whereby contributing improved display quality of the panel.

SUMMARY

An embodiment provides a display panel.

An embodiment provides an electronic device including the display panel.

In an embodiment, a display panel includes a light emitting panel including a plurality of light emitting units; and a color conversion panel including a surface opposite a surface of the light emitting panel (e.g., facing the light emitting panel), where the plurality of light emitting units includes a first light emitting unit and a second light emitting unit.

In such an embodiment, the color conversion panel includes a color conversion layer including a first color conversion region and a second color conversion region and a partition wall defining the first color conversion region and the second color conversion region.

In such an embodiment, the first color conversion region includes first semiconductor nanoparticles and the first color conversion region is configured to (e.g., converts) a third light emitted from the first light emitting unit to a first light.

In such an embodiment, the second color conversion region includes second semiconductor nanoparticles and the second color conversion region is configured to (e.g., converts) a third light emitted from the second light emitting unit to a second light.

In such an embodiment, a first optical diffuser is disposed between the first light emitting unit and the first color conversion region to cover a light extraction surface of the first light emitting unit.

In such an embodiment, a second optical diffuser is disposed between the second light emitting unit and the second color conversion region to cover a light extraction surface of the second light emitting unit.

In such an embodiment, the first optical diffuser and the second optical diffuser are spaced apart from one another.

In such an embodiment, for example as determined in a cross-section of the display panel, a length of the light extraction surface of the first light emitting unit is greater than or equal to about 500 nm (or greater than or equal to about 1 $\mu$m) and less than or equal to about 100 $\mu$m and a ratio of a length of the first optical diffuser to the length of the light extraction surface of the first light emitting unit is greater than or equal to about 1.4:1 and less than or equal to about 60:1.

In such an embodiment, a length of the light extraction surface of the second light emitting unit is greater than or equal to about 500 nm (or greater than or equal to about 1 $\mu$m) and less than or equal to about 100 $\mu$m and a ratio of a length of the second optical diffuser to the length of the light extraction surface of the second light emitting unit is greater than or equal to about 1.4:1 and less than or equal to about 60:1.

In an embodiment, a luminescent peak wavelength of the third light may be greater than or equal to about 360 nm, greater than or equal to about 400 nm, or greater than or equal to about 440 nm.

In an embodiment, a luminescent peak wavelength of the third light may be less than about 500 nm, less than or equal to about 480 nm, or less than or equal to about 470 nm.

In an embodiment, the first light emitting unit and the second light emitting unit may be spaced apart from one another.

In such an embodiment, a partition wall may be optionally disposed between the first light emitting unit and the second light emitting unit.

In an embodiment, a luminescent peak wavelength of the first light may be in a range of greater than or equal to about 500 nm, greater than or equal to about 520 nm, and less than or equal to about 580 nm, or less than or equal to about 560 nm.

In an embodiment, a luminescent peak wavelength of the second light may be in a range of greater than about 580 nm and less than or equal to about 680 nm.

In an embodiment, the first color conversion region may further include a first matrix and optionally metal oxide particles.

In an embodiment, the first semiconductor nanoparticles and optionally the metal oxide particles may be dispersed in the first matrix.

In an embodiment, the second color conversion region may further include a second matrix and optionally metal oxide particles.

In an embodiment, the second semiconductor nanoparticles and optionally the metal oxide particles may be dispersed in the second matrix.

In an embodiment, the first matrix, the second matrix, or a combination thereof may further include a polymer (e.g., an insulating polymer).

In an embodiment, in the cross-section of the display panel, a ratio of a length of the first optical diffuser to a length of the first color conversion region may be in a range of about 0.1 to about 1.2:1, in a range of about 0.1 to about 1:1, in a range of about 0.2 to about 0.8:1, in a range of about 0.3 to about 0.7:1, or a combination thereof.

In an embodiment, for example, as determined in the cross-section of the display panel, a ratio of the length of the second optical diffuser to a length of the second color conversion region may be in a range of about 0.1 to about 1.2:1, in a range of about 0.1 to about 1:1, in a range of about 0.2 to about 0.8:1, in a range of about 0.3 to about 0.7:1, or a combination thereof.

In an embodiment, a length of the first color conversion region may be greater than or equal to about 1 $\mu$m, or greater than or equal to about 3 $\mu$m and less than or equal to about 700 $\mu$m.

In an embodiment, a length of the second color conversion region may be greater than or equal to about 1 $\mu$m, or greater than or equal to about 3 $\mu$m and less than or equal to about 700 $\mu$m.

In an embodiment, in the cross-section of the display panel, a ratio of the length of the first color conversion region to the length of the light extraction surface of the first light emitting unit may be greater than about 1:1 and less than or equal to about 10:1, for example, in a range of about 2 to about 9:1, in a range of about 3 to about 8:1, from about 4 to about 7:1, in a range of about 5 to about 6:1, or a combination thereof.

In an embodiment, in the cross-section of the display panel, a ratio of the length of the second color conversion region to the length of the light extraction surface of the second light emitting unit may be greater than about 1:1 and less than or equal to about 10:1, for example, in a range of about 2 to about 9:1, in a range of about 3 to about 8:1, in a range of about 4 to about 7:1, in a range of about 5 to about 6:1, or a combination thereof.

In an embodiment, the display panel may have an aperture ratio in a range of about 1 to about 100, in a range of about 20 to about 80, in a range of about 30 to about 70, in a range of about 40 to about 60, in a range of about 50 to about 55, or a combination thereof.

In an embodiment, a second partition wall may be disposed between the first optical diffuser and the second optical diffuser.

In an embodiment, the first partition wall and the second partition wall may be an integrated structure (for example, integrally formed with each other as a single unitary and indivisible body).

In an embodiment, the first optical diffuser and/or the second optical diffuser may include inorganic (e.g., metal oxide) particles dispersed in a matrix.

In an embodiment, the inorganic particles may include a zinc oxide, a titanium oxide, a zirconium oxide, a silicon oxide, a barium oxide, an aluminum oxide, or a combination thereof.

In an embodiment, the inorganic particles may have an average particle size of greater than about 70 nm.

In an embodiment, the inorganic particles may have an average particle size in a range of about 75 nm to about 750 nm, about 80 nm to about 700 nm, about 90 nm to about 650 nm, about 100 nm to about 600 nm, about 110 nm to about 550 nm, about 120 nm to about 500 nm, about 130 nm to about 450 nm, about 140 nm to about 400 nm, about 150 nm to about 350 nm, about 200 nm to about 300 nm, or a combination thereof.

In an embodiment, an inorganic amount of the first optical diffuser may be greater than or equal to about 1 weight percent (wt%), or greater than or equal to about 5 wt% and less than or equal to about 50 wt%, less than or equal to about 30 wt%, less than or equal to about 25 wt%, or less than or equal to about 20 wt%, for example, as determined by a thermogravimetric analysis.

In an embodiment, an inorganic amount of the second optical diffuser may be greater than or equal to about 1 wt%, or greater than or equal to about 5 wt% and less than or equal to about 50 wt%, less than or equal to about 30 wt%, less than or equal to about 25 wt%, or less than or equal to about 20 wt%, for example, for example, as determined by a thermogravimetric analysis.

In an embodiment, the first optical diffuser may be disposed adjacent to (for example, in contact with) the first color conversion region. In an embodiment, the display panel may include a light transmitting body or a light transmitting region between the first optical diffuser and the first light emitting unit.

In an embodiment, the second optical diffuser may be disposed adjacent to (for example, in contact with) the second color conversion region. In an embodiment, the display panel may include a light transmitting body or a light transmitting region between the second optical diffuser and the second light emitting unit.

In an embodiment, the display panel may further include an optical auxiliary layer, a predetermined optical path, or a combination thereof between the first color conversion region and the first optical diffuser. In an embodiment, the display panel may further include an optical auxiliary layer, a predetermined optical path, or a combination thereof between the second color conversion region and the second optical diffuser.

In an embodiment, the optical auxiliary layer may include a light transmitting layer, an optical recycling layer, or a combination thereof.

In an embodiment, the first optical diffuser may be disposed on (e.g., directly on) the first light emitting unit.

In an embodiment, the second optical diffuser may be disposed on (e.g., directly on) the second light emitting unit.

In an embodiment, the first optical diffuser may have a height of greater than or equal to about 100 nm and less than or equal to about 10 $\mu$m.

In an embodiment, the second optical diffuser may have a height of greater than or equal to about 100 nm and less than or equal to about 10 $\mu$m.

In an embodiment, an area of a light extraction surface of the first optical diffuser may be at least about two times and at most about 200 times of an area of a light extraction surface of the first light emitting unit.

In an embodiment, an area of a light extraction surface of the second optical diffuser may be at least two times and at most about 200 times of an area of a light extraction surface of the second light emitting unit.

In an embodiment, the light emitting panel may include a micro light emitting diode, an inorganic nano light emitting diode, or a combination thereof.

In an embodiment, a luminance ratio of light entering the first color conversion region with respect to light emitted from the first light emitting unit may be greater than or equal to about 0.05:1, greater than or equal to about 0.1:1, or greater than or equal to about 0.5:1.

In an embodiment, a luminance ratio of light entering the first color conversion region with respect to light emitted from the first light emitting unit may be less than or equal to about 0.95:1, less than or equal to about 0.8:1, or less than or equal to about 0.7:1.

In an embodiment, a luminance ratio of light entering the second color conversion region with respect to light emitted from the second light emitting unit may be greater than or equal to about 0.05:1, greater than or equal to about 0.1:1, or greater than or equal to about 0.5:1.

In an embodiment, a luminance ratio of light entering the second color conversion region with respect to light emitted from the second light emitting unit may be less than or equal to about 0.95:1, less than or equal to about 0.8:1, or less than or equal to about 0.7:1.

In an embodiment, a light entering surface of the first color conversion region, a light entering surface of the second color conversion region, or both may be configured to exhibit a luminance deviation of an incident light of less than or equal to about 30%.

In an embodiment, an electronic device includes the display panel.

In an embodiment, the electronic device may include a portable terminal device, a monitor, a notebook personal computer (PC), a television, an electronic display, a camera, an electronic component for an automobile, or a combination thereof.

In a display panel according to an embodiment, each of micrometer-sized subpixels including semiconductor nanoparticles (e.g., quantum dots) may be provided with light, for example, independently. According to an embodiment, the display panel may achieve an improved display quality (such as an increased contrast ratio and/or a wider viewing angle) and may show improved reliability. According to an embodiment, a total incident light may be uniformly supplied to an entire light-entering surface of the color conversion panel (e.g. color conversion layer) and thus an occurrence of high intensity bright spot phenomenon may be minimized or suppressed (e.g., prevented), and this may enhance the reliability of the display panel as a whole and suppress photooxidation of the semiconductor nanoparticles included in the color conversion layer. According to an embodiment, the display panel may exhibit improved luminance uniformity in each of subpixels.

BRIEF DESCRIPTION OF THE DRAWINGS

FIG. 1A is a perspective view illustrating a display panel including a color conversion panel according to an embodiment.
FIG. 1B is a perspective exploded view illustrating a display panel according to an embodiment,
FIG. 2 is a cross-sectional view of the display panel of FIG. 1A.
FIG. 3 is a plan view illustrating a pixel arrangement of a display panel according to an embodiment.
FIG. 4A is a schematic cross-sectional view of the display panel of FIG. 3 taken along line IV-IV.
FIG. 4B is a schematic cross-sectional view illustrating the backplane of FIG. 4A in detail, in a display device of a non-limiting embodiment,
FIG. 4C is a schematic cross-sectional view illustrating the color conversion panel.
FIG. 5 is a cross-sectional view illustrating a light emitting unit in a display panel according to an embodiment.
FIG. 6 is a cross-sectional view illustrating a light emitting unit in a display panel according to an embodiment.
FIG. 7A is a cross-sectional view illustrating a display panel according to an embodiment.
FIG. 7B is a cross-sectional view illustrating a display panel according to an embodiment.
FIG. 7C is a cross-sectional view illustrating a display panel according to an embodiment.
FIG. 7D is a cross-sectional view illustrating a display panel according to an embodiment.
FIG. 8 schematically shows a production process of a display panel of FIG. 7A according to an embodiment.

DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

If not defined otherwise, a term (including a technical or scientific term) in the specification may be defined as commonly understood by one skilled in the art.

In the drawings, the thickness of layers, films, panels, regions, etc., are exaggerated for clarity. Like reference numerals designate like elements throughout the specification.

Further, in the drawings, size and thickness of each element may be arbitrarily represented for better understanding and ease of description, but the present disclosure is not limited thereto. In the drawings, the thickness of layers, films, panels, regions, etc., may be exaggerated for clarity. In addition, in the drawings, for better understanding and ease of description, the thickness of some layers and areas may be exaggerated

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being on or below the object portion, and does not necessarily mean being on the upper side of the object portion based on a gravitational direction.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "a first component," "a first region," "a first layer" or "a first section" discussed below could be termed a second element, a second component, a second region, a second layer or a second section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In addition, in this specification, the phrase "on a plane" or "in a plane" means viewing a target portion from the top, and the phrase "on a cross-section" or "in a cross-section" means viewing a cross-section formed by vertically cutting a target portion from the side.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, ± 5%, ± 3%, or ± 1% of the stated value.

As used herein, an "aperture ratio" of a pixel is related to a transparent region in a pixel design and may refer to a ratio of a light-sensitive area of a pixel to a total area of that pixel.

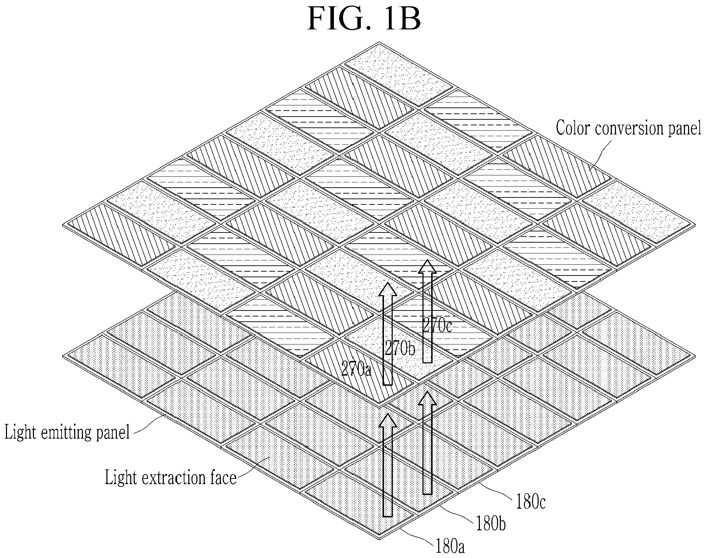

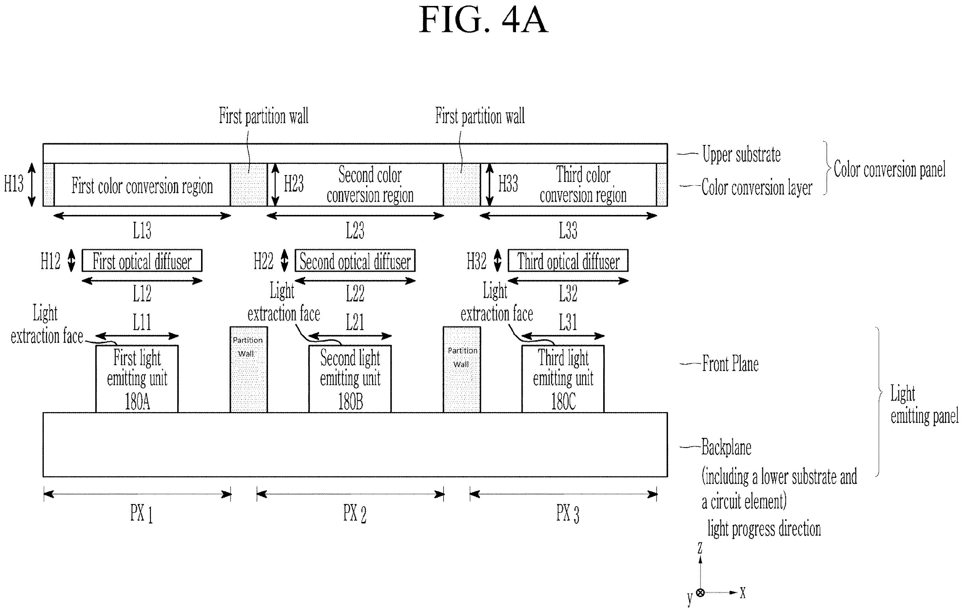

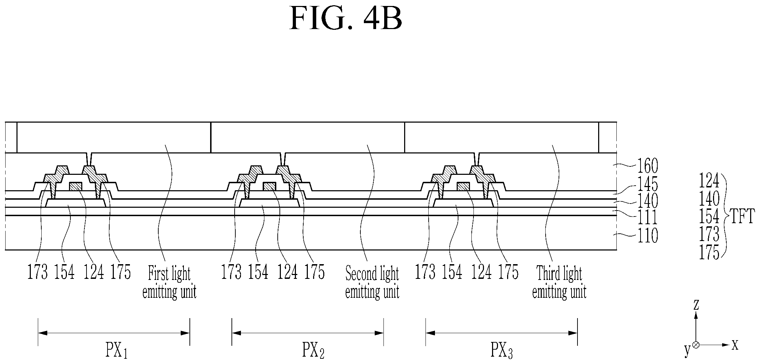

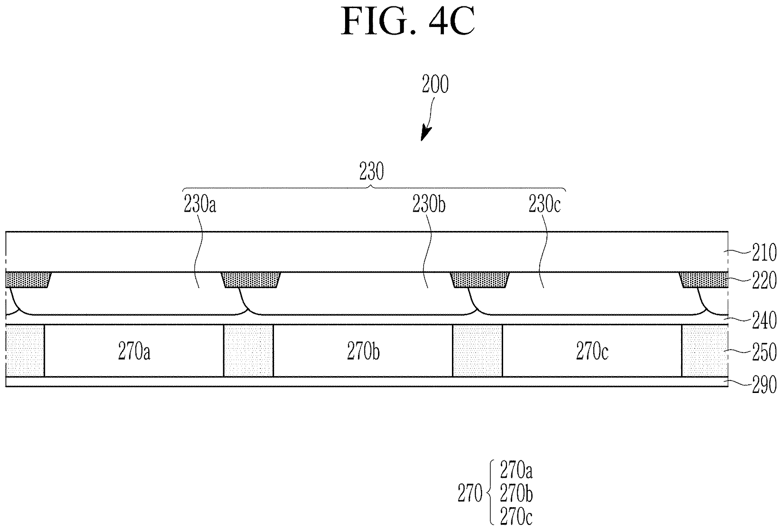

As used herein, a light extraction surface (for example of a light emitting unit) is a surface that is configured to emit light (see FIG. 1B and FIG. 4). In an embodiment, (for example, as determined in a cross-section of a panel), the light extraction surface may be substantially vertical to a light progress direction (e.g., z direction in figures) or may be substantially parallel to a bottom surface of the panel, but is not limited thereto.

In an embodiment, a luminescent peak wavelength or other photoluminescent properties may be readily and reproducibly measured by using a spectrophotometer (e.g., Hitachi F-7000 spectrophotometer or Quantaurus-QY Plus UV-NIR absolute PL quantum yield spectrometer from Hamamatsu).

In an embodiment, luminance is a photometric measure of the luminous intensity per unit area of light travelling in a given direction (for example, reaching a given object). It describes the amount of light that passes through or arrives at or is emitted from. The luminance may be readily and reproducibly measured by using an appropriate equipment for example spectroradiometer (e.g., CS-2000 or CS-2000A from Konica Minolta) according to a manual provided from a manufacturer.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described in detail with reference to the accompanying drawings.

In an embodiment, a length of an optical diffuser may be a greatest length thereof extending along a direction substantially parallel to a bottom surface of the panel as measured above the light extraction surface of the light emitting unit.

In an embodiment, as determined in a cross-section of a display panel, a length of a light conversion region may be a length of a side facing the optical diffuser.

As used herein, the term "combination" may refer to a mixture (e.g., homogeneous or inhomogeneous one), a laminated structure of two or more, or a combined range. As used herein, the upper and lower endpoints set forth for various values may be independently combined to provide a range.

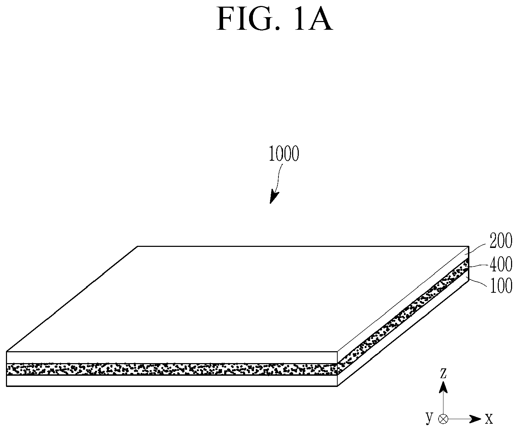

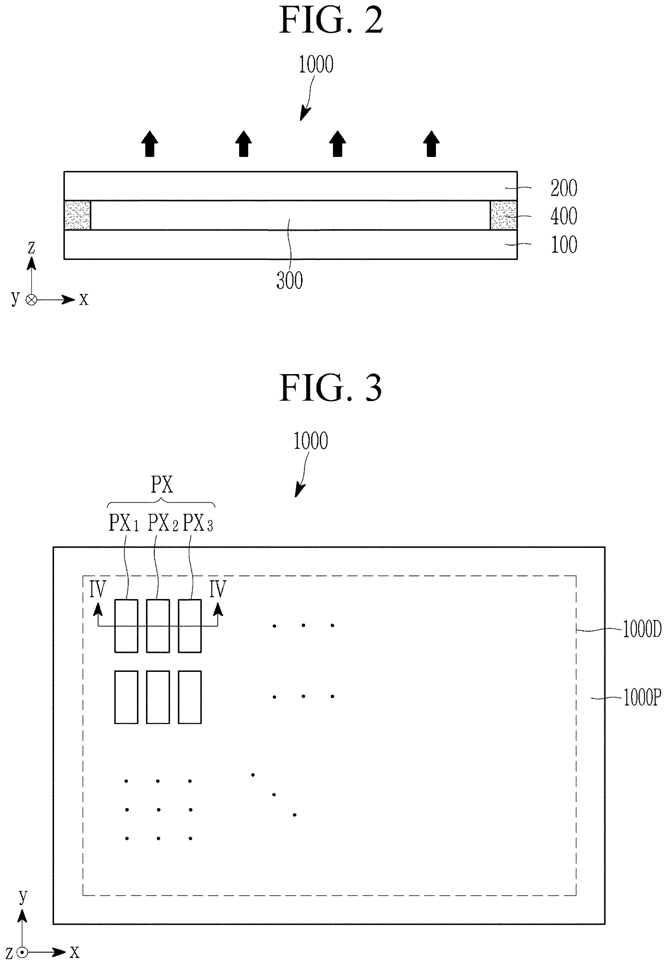

Hereinafter, a display panel according to an embodiment will be described. FIG. 1A is a perspective view illustrating a display panel according to one or more embodiments, FIG. 2 is a cross-sectional view of the display panel of FIG. 1A, FIG. 3 is a plan view illustrating an arrangement of pixels of the display panel of FIG. 1A, and FIG. 4 is a cross-sectional view of the display panel of FIG. 3 taken along line IV-IV.

Referring to FIGS. 1A and 2, the display panel 1000 according to one or more embodiments include a light emitting panel 100 and a color conversion panel 200. The display panel according to an embodiment may further include a light transmitting layer 300 between the light emitting panel 100 and the color conversion panel 200, a binding element 400 for combining the light emitting panel 100 and the color conversion panel 200, or a combination thereof.

The light emitting panel 100 and the color conversion panel 200 may face each other (optionally, with the light transmitting layer 300 therebetween), and the color conversion panel 200 may be disposed in a direction in which light is emitted from the light emitting panel 100 or in a light progress direction. In a display panel according to an embodiment, a manner of disposing a binding element 400 is not particularly limited. In an embodiment, a binding element 400 may be disposed along the edges of the light emitting panel 100 and the color conversion panel 200. In an embodiment, the binding element 400 may be, for example, a sealant.

In a display panel according to an embodiment, a binding element 400 may be an adhesive such as an optically clear adhesive and a binding element 400 or the adhesive may be disposed along at least a portion of a surface of the light emitting panel and at least a portion of a surface of the color conversion panel to combine the light emitting panel and the color conversion panel.

Referring to FIG. 3, a display panel 1000 according to one or more embodiments may include a display area 1000D for displaying an image and a nondisplay area 1000P around the display area 1000D where the binding element 400 may be located.

The display area 1000D may include a plurality of pixels PXs arranged along a row (e.g., x direction) and/or a column (e.g., y direction), and each pixel PX may include a plurality of sub-pixels $PX_1$, $PX_2$, and $PX_3$ displaying different colors. In FIG. 3, an embodiment having a configuration in which three sub-pixels $PX_1$, $PX_2$, and $PX_3$ constitute one pixel PX is illustrated, but the configuration is not limited thereto. An additional sub-pixel such as a white sub-pixel may be further included, and one or more sub-pixel that display a same color may be included. The plurality of pixels PXs may be arranged in, for example, a Bayer matrix form, a PenTile matrix form, and/or a diamond matrix form, but is not limited thereto

Each of the sub-pixels $PX_1$, $PX_2$, and $PX_3$ may display a color of three primary colors or a combination of three primary colors, for example, green, red, blue, or a combination thereof. In an embodiment, the first sub-pixel $PX_1$ may display green (or red), the second sub-pixel $PX_2$ may display red (or green), and the third sub-pixel $PX_3$ may display blue.

In the drawings, an embodiment in which all sub-pixels have a same size as each other is illustrated, but the disclosure is not limited thereto. Alternatively, at least one of the sub-pixels may be larger or smaller than the other sub-pixels. In the drawings, an embodiment in which all sub-pixels have a same shape as each other may be illustrated, but the disclosure is not limited thereto. Alternatively, at least one of the sub-pixels may have a different shape from other sub-pixels.

Referring to FIG. 1B, FIG. 4A, FIG. 4B, and FIG. 5, the light emitting panel 100 and the color conversion panel 200 will be described.

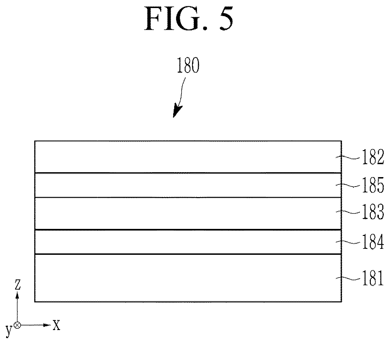

The light emitting panel 100 may include a plurality of light emitting units 180 (shown in FIG. 5), each of which emits light of a predetermined wavelength spectrum. The light emitting units 180 (e.g., a first light emitting unit 180a, a second light emitting unit 180b, a third light emitting unit 180c) may be disposed to correspond to each subpixels the sub-pixels $PX_1$, $PX_2$, and $PX_3$. The front plane of the light emitting panel may face the color conversion panel. The light emitting panel may include a back plane below the front plane. Light may be emitted from the light extraction surface (e.g., light extraction face in FIG. 4A) of the light emitting unit and the emitted light may progress in z direction z or a thickness direction of the light emitting panel 100 to the color conversion panel 200. (see FIG. 1A, FIG. 4A, and FIG. 4B).

Each of the plurality of light emitting units may be the same as or different from each other. In an embodiment, the light emitting units 180, which are disposed corresponding to the sub-pixels $PX_1$, $PX_2$, and $PX_3$, respectively, may emit light of same or different wavelength spectrum(s). In an embodiment, each of the light emitting units 180 corresponding to the sub-pixels $PX_1$, $PX_2$, and $PX_3$ may emit light of a same wavelength spectrum. In an embodiment, the plurality of light emitting units may emit a third light.

In an embodiment, a luminescent peak wavelength of the third light may be greater than or equal to about 360 nanometers (nm), greater than or equal to about 400 nm, or greater than or equal to about 440 nm. The luminescent peak wavelength of the third light may be less than about 500 nm, less than or equal to about 480 nm, or less than or equal to about 470 nm. In an embodiment, the light emitting unit may emit light of a blue wavelength spectrum, and the maximum luminescent peak wavelength thereof may be in a range of about 400 nm to about 500 nm, or may be greater than or equal to about 400 nm and less than about 500 nm. The luminescent peak wavelength of the third light (or the blue light) may be in a range of about 360 nm to about 500 nm, in a range of about 410 nm to about 490nm, in a range of about 420nm to about 495 nm or in a range of about 430 nm to about 480 nm, or in a range of about 440nm to about 470 nm, or a combination thereof.

The plurality of the light emitting units may be arranged to form an array (see FIG. 1B)

In an embodiment, for example, in a cross-section of the display panel, a length of the light extraction surface of the light emitting unit (for example, a first light emitting unit 180a, a second light emitting unit 180b, and a third light emitting unit 180c, hereinafter, simply referred to as "light emitting unit") may be greater than or equal to about 500 nm, greater than or equal to about 900 nm, greater than or equal to about 1 micrometer ($\mu$m), 1.5 $\mu$m, greater than or equal to about 2 $\mu$m, greater than or equal to about 2.5 $\mu$m, greater than or equal to about 3 $\mu$m, greater than or equal to about 3.5 $\mu$m, greater than or equal to about 4 $\mu$m, greater than or equal to about 4.5 $\mu$m, greater than or equal to about 5 $\mu$m, greater than or equal to about 5.5 $\mu$m, greater than or equal to about 6 $\mu$m, greater than or equal to about 6.5 $\mu$m, greater than or equal to about 7 $\mu$m, greater than or equal to about 7.5 $\mu$m, greater than or equal to about 8 $\mu$m, greater than or equal to about 8.5 $\mu$m, greater than or equal to about 9 $\mu$m, greater than or equal to about 9.5 $\mu$m, greater than or equal to about 10 $\mu$m, greater than or equal to about 13 $\mu$m, greater than or equal to about 15 $\mu$m, greater than or equal to about 17 $\mu$m, greater than or equal to about 19 $\mu$m, greater than or equal to about 20 $\mu$m, great-

er than or equal to about 21 $\mu$m, greater than or equal to about 24 $\mu$m, greater than or equal to about 25 $\mu$m, greater than or equal to about 27 $\mu$m, greater than or equal to about 29 $\mu$m, greater than or equal to about 30 $\mu$m, greater than or equal to about 31 $\mu$m, greater than or equal to about 33 $\mu$m, greater than or equal to about 35 $\mu$m, greater than or equal to about 37 $\mu$m, greater than or equal to about 39 $\mu$m, greater than or equal to about 40 $\mu$m, greater than or equal to about 41 $\mu$m, greater than or equal to about 43 $\mu$m, greater than or equal to about 45 $\mu$m, greater than or equal to about 47 $\mu$m, greater than or equal to about 49 $\mu$m, or greater than or equal to about 50 $\mu$m. In an embodiment, the "cross-section" of an object (e.g., a panel) may be taken along a long axis or a short axis of a front surface (or a top surface) of a pixel(s).

In an embodiment, for example, in a cross-section of the display panel, a length of the light extraction surface may be a length of a longest straight line extending substantially parallel to a bottom surface of the panel, but is not limited thereto. In an embodiment, a length of a light emitting surface of a given light emitting unit may be a dimension (e.g., a diameter of a circle or a side length of a polygon) thereof, but is not limited thereto. In an embodiment, a light emitting unit may include a micro-light emitting diode ($\mu$-LED), quantum nano light-emitting diode (QNED), or a combination thereof, and the dimension of the light emitting surface of the unit may be determined taking into consideration a desired pixel per inch (PPI) of the display device.

A length of the light extraction surface (e.g., a dimension of light emitting surface) of the light emitting unit may be in a micro-meter scale. The length of the light extraction surface of the light emitting unit may be less than or equal to about 100 $\mu$m, less than or equal to about 90 $\mu$m, less than or equal to about 85 $\mu$m, less than or equal to about 80 $\mu$m, less than or equal to about 75 $\mu$m, less than or equal to about 70 $\mu$m, less than or equal to about 65 $\mu$m, less than or equal to about 60 $\mu$m, less than or equal to about 55 $\mu$m, less than or equal to about 50 $\mu$m, less than or equal to about 45 $\mu$m, less than or equal to about 40 $\mu$m, less than or equal to about 35 $\mu$m, less than or equal to about 30 $\mu$m, less than or equal to about 25 $\mu$m, less than or equal to about 20 $\mu$m, less than or equal to about 15 $\mu$m, less than or equal to about 10 $\mu$m, or less than or equal to about 5 $\mu$m.

The light extraction surface (e.g., a front surface or a top surface) of an individual light emitting unit may have any shape, which is not particularly limited. A shape of the light extraction surface may include a polygon shape such as a trigonal shape, a tetragonal shape (e.g., a square, a rectangle, or the like), a pentagon shape, a circle, an ellipse, or a combination thereof.

An area of the light extraction surface may be less than or equal to about 10,000 $\mu$m², less than or equal to about 9,000 $\mu$m², less than or equal to about 8,000 $\mu$m², less than or equal to about 7000 $\mu$m², less than or equal to about 6,000 $\mu$m², less than or equal to about

5,000 μm², less than or equal to about 4,000 μm², less than or equal to about 3,000 μm², less than or equal to about 2,000 μm², less than or equal to about 1,000 μm², less than or equal to about 900 μm², less than or equal to about 800 μm², less than or equal to about 700 μm², less than or equal to about 600 μm², less than or equal to about 500 μm², less than or equal to about 400 μm², less than or equal to about 300 μm², less than or equal to about 250 μm², less than or equal to about 200 μm², or less than or equal to about 100 μm².

An area of the light extraction surface may be greater than or equal to about 0.25 μm², greater than or equal to about 0.5 μm², greater than or equal to about 1 μm², greater than or equal to about 3 μm², greater than or equal to about 5 μm², greater than or equal to about 7 μm², greater than or equal to about 10 μm², greater than or equal to about 11 μm², greater than or equal to about 13 μm², greater than or equal to about 15 μm², greater than or equal to about 19 μm², greater than or equal to about 20 μm², greater than or equal to about 21 μm², greater than or equal to about 23 μm², greater than or equal to about 25 μm², greater than or equal to about 27 μm², greater than or equal to about 29 μm², greater than or equal to about 30 μm², greater than or equal to about 31 μm², greater than or equal to about 33 μm², greater than or equal to about 35 μm², greater than or equal to about 37 μm², greater than or equal to about 39 μm², greater than or equal to about 40 μm², greater than or equal to about 41 μm², greater than or equal to about 43 μm², greater than or equal to about 45 μm², greater than or equal to about 47 μm², greater than or equal to about 49 μm², greater than or equal to about 50 μm², greater than or equal to about 55 μm², greater than or equal to about 60 μm², greater than or equal to about 65 μm², greater than or equal to about 70 μm², greater than or equal to about 75 μm², greater than or equal to about 80 μm², greater than or equal to about 85 μm², greater than or equal to about 90 μm², greater than or equal to about 95 μm², greater than or equal to about 100 μm², greater than or equal to about 120 μm², greater than or equal to about 140 μm², greater than or equal to about 160 μm², greater than or equal to about 180 μm², greater than or equal to about 200 μm², greater than or equal to about 250 μm², greater than or equal to about 300 μm², greater than or equal to about 350 μm², greater than or equal to about 400 μm², greater than or equal to about 450 μm², or greater than or equal to about 500 μm².

A cross-section of the light emitting unit may have any shape, which is not particularly limited. A shape of the cross-section of the light emitting unit may be a square, a rectangle, a trapezoid, a rhombus, a parallelogram, or the like.

In an embodiment, the light emitting units (e.g., a first light emitting unit 180a and a second light emitting unit 180b included in the light emitting panel) may be spaced apart from another. A partition wall (e.g., a passivation layer or a bank layer) or a pixel defining layer may be disposed between the first light emitting unit and the second light emitting unit. The partition wall may be disposed in a way such that at least a portion of the partition wall may overlap a first partition wall, a second partition wall, or both that will be described herein. A material for the partition wall, the passivation layer, or a bank layer may include an organic material, an inorganic material, or a combination thereof, and is not particularly limited. In an embodiment, the partition wall may include a material for the first partition wall and/or the second partition wall, which are described herein.

The backplane of the light emitting panel may include, for example, a lower substrate 110, and a circuit element for switching and/or driving the light emitting units. In an embodiment, the light emitting units may be individually or independently controlled.

In an embodiment, the light emitting panel 100 may include a lower substrate 110, a buffer layer 111, a thin film transistor TFT, a light emitting unit 180, and an encapsulation layer.

The lower substrate 110 may be an inorganic material substrate (e.g. a glass substrate), an organic-inorganic hybrid substrate, a metal substrate, an organic material substrate (e.g., a polymer substrate) or a combination thereof. In an embodiment, the lower substrate may be a polymer substrate. The polymer substrate may include, for example, polyimide, polyamide, poly(amide-imide), polyethylene terephthalate, polyethylene naphthalene, polymethyl methacrylate, polycarbonate, a copolymer thereof, or a combination thereof, but is not limited thereto.

The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer (i.e., a single layer structure) or two or more layers (i.e., a multilayer structure), and may cover a portion of or the entire surface of the lower substrate 110. Alternatively, the buffer layer 111 may be omitted.

The thin film transistor TFT may be a three-terminal element for switching and/or driving the light emitting unit 180, and one or two or more may be included for each sub-pixel. The thin film transistor TFT may include a gate electrode 124, a semiconductor layer 154 overlapping the gate electrode 124, a gate insulating layer 140 between the gate electrode 124 and the semiconductor layer 154, and a source electrode 173 and a drain electrode 175 electrically connected to the semiconductor layer 154. In the drawings, a coplanar top gate structure is shown as an embodiment, but the structure is not limited thereto and may have various structures.

The gate electrode 124 may be electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but not being limited thereto. The semiconductor layer 154 may include a channel region and doped regions disposed on opposing sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an embodiment in which the gate insulating layer 140 is disposed or formed on the entire surface of the lower substrate 110 is illustrated, but the disclosure is not limited thereto and may be selectively formed between the gate electrode 124 and the semiconductor layer 154. The gate insulating layer 140 may be formed of (or defined by) one layer or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 is electrically connected to a data line (not shown), and the drain electrode 175 is electrically connected to a light emitting unit 180 to be described later.

An interlayer insulating layer 145 may be additionally disposed or formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one layer or two or more layers.

A protective layer 160 may be disposed or formed on the thin film transistor TFT. The protective layer 160 may be, for example, a passivation layer. The protective layer 160 may include an organic material, an inorganic material, or an organic-inorganic material, for example, polyacrylic, polyimide, polyamide, poly(amide-imide), or a combination thereof, but is not limited thereto. The protective layer 160 may be formed of one layer or two or three or more layers.

In the light emitting panel according to an embodiment, the plurality of light emitting units 180a, 180b, 180c may be disposed for each of sub-pixels $PX_1$, $PX_2$, and $PX_3$. The plurality of light emitting units 180a, 180b, and 180c disposed in each sub-pixel $PX_1$, $PX_2$, and $PX_3$ respectively may be independently driven. The light emitting units may be, for example, an inorganic light emitting element or diode (e.g., a light emitting diode including an inorganic emitter). The inorganic light emitting element may be a micro LED, inorganic nano light emitting diode, or a combination thereof. In an embodiment, the light emitting units 180 may be a quantum dot light emitting diode, a perovskite light emitting diode, a micro light emitting diode, or a combination thereof.

FIGS. 5 to 6 are cross-sectional views showing embodiments of light emitting units, respectively.

Referring to FIG. 5, an embodiment of the light emitting unit 180 may include a first electrode 181 and a second electrode 182 facing each other; and a light emitting layer 183 between the first electrode 181 and the second electrode 182, and the light emitting layer 183 is electrically connected to the second electrode 182 and the light emitting layer 183. In an embodiment, the first electrode 181 and the second electrode 182 may face each other. In an embodiment, the light emitting layer 183 may be disposed between the first electrode 181 and the second electrode 182 (e.g., facing each other).

In an embodiment, the first electrode 181 and the second electrode 182 may face each other along a thickness direction (for example, the z direction), but it is not limited thereto. Any one selected from the first electrode 181 and the second electrode 182 may be an anode and the other may be a cathode. The first electrode 181 may be a light transmitting electrode, a translucent electrode, or a reflective electrode, and the second electrode 182 may be a light transmitting electrode, a translucent electrode, or a reflective electrode.

The light transmitting electrode or translucent electrode may include or may be, for example, a single layer or multiple layers of metal thin film including conductive oxides such as indium tin oxide (ITO), indium zinc oxide (IZO), zinc oxide (ZnO), tin oxide (SnO), aluminum tin oxide (AITO), and/or fluorine-doped tin oxide (FTO) and/or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but is not limited thereto.

The light emitting layer 183 may include a light emitter (e.g., an inorganic based light emitter) emitting light of a third emission spectrum (hereinafter, a third light). The third emission spectrum may belong to a relatively short wavelength region in the visible light wavelength spectrum and for example, a blue emission spectrum.

The light emitting layer or the light emitter may include an inorganic light emitter, and the inorganic light emitter may be an inorganic semiconductor, a quantum dot, a perovskite material, or a combination thereof.

In an embodiment, the light emitting layer 183 or the inorganic light emitter may include a p-n diode layer that includes a n-doped semiconductor layer, a p-doped semiconductor layer, and an active layer (e.g., a quantum well layer(s)) between the n-doped semiconductor layer and the p-doped semiconductor layer. In an embodiment, a front surface (or a top surface) of the p-n diode layer may correspond to the light extraction surface. The p-n diode layer may include one or more layers based on a II-VI material (e.g. ZnSe) or a III-V material. The III-V material may include a III-V nitride material (e.g. GaN, AlN, InN, InGaN, and/or an alloy thereof), a III-V phosphide material (e.g. GaP, AlGaInP, and/or an alloy thereof), or a III-V arsenide material (e.g., AlGaAs).

The p-n diode layer may include an indium gallium nitride (InGaN), a gallium nitride (GaN), an aluminum gallium nitride, a gallium phosphide (GaP), an aluminum gallium indium phosphide (AlGaInP), an aluminum gallium phosphide (AlGaP), a zinc selenide(ZnSe), or a combination thereof, which may be p-doped or n-doped, respectively.

In an embodiment, the p-n diode layer may be designed to emit blue light and the material may include a nitride based material. In an embodiment, the p-n diode layer may include GaN, AlGaN, InGaN, or a combination thereof.

In an embodiment, the n-doped layer may include n-GaN, n-AlGaN, n-InGaN, n-AlGaInP, or a combination thereof, and the p- doped layer may include a p-AlGaN, a p-GaN, a p-InGaN, a p-AlGaInP, or a combination thereof, but are not limited thereto. The quantum well layer may include a variety of materials. The quantum well layer may include a single quantum well layer (SQW) or a multi quantum well layer (MQW). The number of quantum well layer(s) may be greater than or equal to 1, greater than or equal to about 3, and less than or equal to about 10, or less than or equal to about 8. A thickness of each layer may be selected appropriately and is not particularly limited.

In an embodiment, the light emitting unit may further include an auxiliary layer 184 and 185 between the first electrode 181 and the light emitting layer 183 and/or between the second electrode 182 and the light emitting layer 183, which may be a charge auxiliary layer to control injection and/or mobility of charge carriers, respectively. Each of the auxiliary layers 184 and 185 may be defined by one layer or two or more layers, and may be, for example, a hole injection layer, a hole transport layer, an electron blocking layer, an electron injection layer, an electron transport layer, a hole blocking layer, or a combination thereof. In some embodiments, one or both of the auxiliary layers 184 and 185 may be omitted.

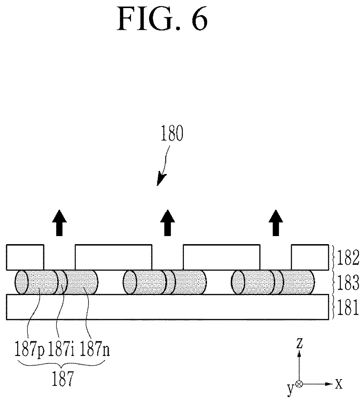

Referring to FIG. 6, the light emitting unit 180 may include a first electrode 181, a second electrode 182, and a light emitting layer 183 including a plurality of nanostructures 187.

One selected from the first electrode 181 and the second electrode 182 may be an anode and the other may be a cathode. The first electrode 181 and the second electrode 182 may be electrodes patterned according to arrangement directions of the plurality of nanostructures 187. Details for the first electrode and the second electrodes are the same as those described above.

The light emitting layer 183 may include a plurality of nanostructures 187, and each of the sub-pixels $PX_1$, $PX_2$, and $PX_3$ may include a plurality of nanostructures 187. The plurality of nanostructures 187 may be arranged along one direction, but the disclosure is not limited thereto. The nanostructures 187 may be a compound semiconductor to emit light of a set or predetermined wavelength spectrum when an electric current is applied, and may be, for example, linear nanostructures such as nanorods and/or nanoneedles. The diameter or long diameter of the nanostructures 187 may be, for example, several to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5, greater than or equal to about 5.0; in a range of about 1 to about 20, in a range of about 1.5 to about 20, in a range of about 2.0 to about 20, in a range of about 3.0 to about 20, in a range of about 4.0 to about 20, in a range of about 4.5 to about 20, in a range of about 5.0 to about 20, or a combination thereof.

Each of the nanostructures 187 may include a p-type region 187p, an n-type region 187n, and a multiple quantum well region 187i, and may emit light from the multiple quantum well region 187i. The nanostructures 187 may include, for example, gallium nitride (GaN), indium gallium nitride (InGaN), aluminum gallium nitride (AlGaN), or a combination thereof, but is not limited thereto. The nanostructures 187 may have, for example, a core-shell structure.

The plurality of nanostructures 187 may emit a third light and details of the third light are the same as those described herein.

The color conversion panel 200 may convert the third light supplied from the light emitting panel 100 into a light of a different spectrum (e.g., a first light or a second light), and may emit the converted light toward an observer (not shown). In an embodiment, for example, as shown in FIG. 4C, the color conversion panel 200 may include a color conversion layer 270 that includes a first color conversion region 270a and a second color conversion region 270b; and a first partition wall 250 defining the first color conversion region 270a and the second color conversion region 270b, respectively. The color conversion layer 270 may further include a third (light transmitting or color conversion) region 270c. The color conversion layer 270 may be disposed on an upper substrate 210. The substrate or the color conversion panel 200 may further include a light blocking pattern 220 corresponding to the partition wall. A color filter layer 230 may be further provided between the color conversion layer 270 and the upper substrate 210.

The upper substrate 210 may be a substrate including an insulating material. The substrate may include glass; various polymers such as a polyester of polyethylene terephthalate (PET), polyethylene naphthalate (PEN), and the like, polycarbonate, and polyacrylate; a polysiloxane (e.g., polydimethylsiloxane (PDMS)); an inorganic material such as $Al_2O_3$ or ZnO; or a combination thereof, but is not limited thereto. A thickness of the substrate may be appropriately selected taking into consideration a substrate material but is not particularly limited. The substrate may be a flexible substrate. The substrate may have a transmittance of greater than or equal to about 50%, greater than or equal to about 60%, greater than or equal to about 70%, greater than or equal to about 80%, or greater than or equal to about 90% for light emitted from semiconductor nanoparticles that are described herein.

The color conversion layer 270 may face the light emitting unit 180 of the light emitting panel 100. The color conversion layer 270 may include a plurality of color conversion regions to convert an emission spectrum of light (e.g., a third light) supplied from the light emitting panel 100 into other emission spectrum. In an embodiment, the color conversion region may, for example, convert light in the emission spectrum supplied from the light emitting panel 100 into light in the emission spectrum of the color displayed by each of the sub-pixels $PX_1$, $PX_2$, and $PX_3$.

In an embodiment, the color conversion layer 270 may include the first color conversion region 270a and the second color conversion region 270b. The first color conversion region 270a may include a first semiconductor nanoparticle(s) (herein, the term "semiconductor nanoparticle" may refer to a single particle or a plurality of particles), for converting a third light emitted from the first light emitting unit into a first light. In an embodiment, the second color conversion region 270b may include a second semiconductor nanoparticle(s), for converting a third light emitted from the second light emitting unit into a second light. The color conversion layer 270 may further include a third (light transmitting or color conversion) region 270c, for passing a third light supplied from the light emitting panel therethrough or converting the third light into a light of a different spectrum. The third color (light transmitting or color conversion) region 270c may include or may not include a third semiconductor nanoparticle. The third semiconductor nanoparticle may down-convert incident light (e.g. provided from the light emitting panel) in an ultraviolet wavelength region into a blue light (B).

Referring to FIGS. 4A and 4C, the color conversion layer 270 may include a first color conversion region 270a included in the first sub-pixel $PX_1$ and including first semiconductor nanoparticles, a second color conversion region 270b included in the second sub-pixel $PX_2$ and including second semiconductor nanoparticles, and a light transmitting or third color conversion region 270c included in the third sub-pixel $PX_3$ and including or not including third semiconductor nanoparticle(s). Each of the color conversion regions may be defined by a partition wall.

The first semiconductor nanoparticles included in the first color conversion region 270a may convert the third light emitted from the light emitting panel 100 into a first light of a first emission spectrum that may be the same as the wavelength spectrum of the color displayed by the first sub-pixel $PX_1$. The first emission spectrum may be different from the third emission spectrum and may be a longer wavelength spectrum than the third light. A luminescent peak wavelength of the first light may be present in a wavelength range of greater than or equal to 500 nm, greater than or equal to 510 nm, greater than or equal to about 520 nm, greater than or equal to about 530 nm, greater than or equal to about 540 nm, or greater than or equal to about 550 nm and less than or equal to about 580 nm, less than or equal to about 570 nm, less than or equal to about 560 nm, less than or equal to about 550 nm, or any one range derived from the stated wavelengths. The first light may be green light (G).

The second semiconductor nanoparticles included in the second color conversion area 270b may convert the third light emitted from the light emitting panel 100 into a second light of a second emission spectrum that may be the same as the wavelength spectrum of the color displayed by the second sub-pixel $PX_2$. The second emission spectrum may be different from the first and third emission spectra, respectively, and may be a longer wavelength spectrum than the third light. A luminescent peak wavelength of the second light may be present in a wavelength range of greater than or equal to about 580 nm, greater than or equal to about 590 nm, greater than or equal to about 600 nm, greater than or equal to about 610 nm, greater than or equal to about 620 nm, or greater than or equal to about 625 nm and less than or equal to about 680 nm, less than or equal to about 670 nm, less than or equal to about 650 nm, less than or equal to about 640 nm, or any one range derived from the stated wavelengths. The second light may be a red light (R).

The third light may be blue light (B). Details of the third light or blue light are the same as those described herein.

In an embodiment, a length of the first color conversion region L13, a length of the second color conversion region L23, or a length of the third color conversion or light transmitting region L33 may be greater than or equal to about 1 $\mu$m, greater than or equal to about 3 $\mu$m, greater than or equal to about 5 $\mu$m, greater than or equal to about 7 $\mu$m, greater than or equal to about 9 $\mu$m, greater than or equal to about 11 $\mu$m, greater than or equal to about 15 $\mu$m, greater than or equal to about 20 $\mu$m, greater than or equal to about 25 $\mu$m, greater than or equal to about 30 $\mu$m, greater than or equal to

about 35 μm, greater than or equal to about 40 μm, greater than or equal to about 45 μm, greater than or equal to about 50 μm, greater than or equal to about 60 μm, greater than or equal to about 70 μm, greater than or equal to about 80 μm, greater than or equal to about 90 μm, greater than or equal to about 100 μm, greater than or equal to about 130 μm, greater than or equal to about 150 μm, greater than or equal to about 170 μm, greater than or equal to about 190 μm, greater than or equal to about 200 μm, greater than or equal to about 230 μm, greater than or equal to about 250 μm, greater than or equal to about 270 μm, greater than or equal to about 290 μm, greater than or equal to about 300 μm, greater than or equal to about 330 μm, greater than or equal to about 350 μm, greater than or equal to about 370 μm, greater than or equal to about 390 μm, or greater than or equal to about 450 μm. A length of the first color conversion region L13, a length of the second color conversion region L23, or a length of the third color conversion or light transmitting region L33 may be less than or equal to about 700 μm, less than or equal to about 600 μm, less than or equal to about 650 μm, less than or equal to about 550 μm, less than or equal to about 500 μm, less than or equal to about 450 μm, less than or equal to about 400 μm, less than or equal to about 350 μm, less than or equal to about 300 μm, less than or equal to about 250 μm, less than or equal to about 200 μm, less than or equal to about 180 μm, less than or equal to about 150 μm, less than or equal to about 130 μm, less than or equal to about 100 μm, less than or equal to about 90 μm, less than or equal to about 80 μm, less than or equal to about 70 μm, less than or equal to about 60 μm, less than or equal to about 50 μm, or less than or equal to about 40 μm.

In an embodiment, for example, as determined in a cross-section of a display device, a ratio of a length of the first color conversion region to a length of the first light emitting unit, a ratio of a length of the second color conversion region to a length of the second light emitting unit, or a ratio of a length of the third region to a length of the third light emitting unit may be greater than about 1:1 and less than or equal to about 10:1, for example, in a range of about 1.5 to about 9.5, in a range of about 2 to about 9, in a range of about 2.5 to about 8.5, in a range of about 3 to about 8, in a range of about 3.5 to about 7.5, in a range of about 4 to about 7, in a range of 4.5 to about 6.5, in a range of about 5 to about 6, or a combination thereof.

In an embodiment, for example, as determined in a cross-section of a display device, a thickness of the first color conversion region, a thickness of the second color conversion region, or a thickness of the third color conversion region, H13, H23, H33 is not particularly limited and may be selected appropriately. In an embodiment, for example as determined in a cross-section of a display device, a thickness of the first color conversion region H13, a thickness of the second color conversion region H23, or a thickness of the third color conversion region H33 may be each independently greater than or equal to about 1 μm, greater than or equal to about 3 μm, greater than or equal to about 5 μm, greater than or equal to about 7 μm, greater than or equal to about 9 μm, greater than or equal to about 11 μm, greater than or equal to about 13 μm, greater than or equal to about 15 μm, greater than or equal to about 17 μm, or greater than or equal to about 19 μm. The thickness of the color conversion region (e.g., the first color conversion region H13, a thickness of the second color conversion region H23, or a thickness of the third color conversion region H33) may be less than or equal to about 30 μm, less than or equal to about 25 μm, or less than or equal to about 20 μm.

In each of the color conversion regions, the first semiconductor nanoparticle, the second semiconductor nanoparticle, and optionally the third semiconductor nanoparticle (for example, in embodiments where the third semiconductor nanoparticle is present) may convert an emission spectrum of incident light supplied from the light emitting panel 100 into light of an emission spectrum different from the emission spectrum of incident light. In an embodiment, the first semiconductor nanoparticle and the second semiconductor nanoparticle may convert the third light into the first light and the second light. In an embodiment, the third semiconductor nanoparticle may convert an incident light (for example, belonging to an ultraviolet wavelength region) into blue light.

In an embodiment, the semiconductor nanoparticle may include a semiconductor nanocrystal, capable of exhibiting a quantum confinement effect. The semiconductor nanoparticle such as a quantum dot may absorb light from an excitation source and may emit light corresponding to a bandgap energy thereof. The bandgap energy of the semiconductor nanoparticle may vary with the size of the nanoparticle, the composition of the nanoparticle, or a combination thereof. A toxic heavy metal such as cadmium may pose somewhat serious concerns, for example, may pose an environmental issue, a health issue, or a combination thereof, and may be listed as a restricted element under Restriction of Hazardous Substances Directive (RoHS) in many countries. In an embodiment, the semiconductor nanoparticle may not include cadmium (Cd), lead (Pb), mercury (Hg), or a combination thereof.

The semiconductor nanoparticle (i.e., the first semiconductor nanoparticle, the second semiconductor nanoparticle, the third semiconductor nanoparticle, or a combination thereof) may have a core-shell structure having a (semiconductor nanocrystal) core and a (semiconductor nanocrystal) shell disposed on the core. In an embodiment, the semiconductor nanoparticle, the semiconductor nanocrystal core, and/or the semiconductor nanocrystal shell may include a Group II-VI compound, a Group III-V compound, a Group IV-VI compound, a Group IV element or compound, a Group I-III-VI compound, a Group I-II-IV-VI compound, or any combinations thereof. In an embodiment, the quantum dots may not include cadmium, lead, mercury, or any combinations thereof.

In an embodiment, the Group II-VI compound may be selected from a binary element compound selected from CdSe, CdTe, ZnS, ZnSe, ZnTe, ZnO, HgS, HgSe, HgTe, MgSe, MgS, and a combination thereof; a ternary element compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a combination thereof; and a quaternary element compound selected from HgZnTeS, CdZnSeS, CdZnSeTe, CdZnSTe, CdHgSeS, CdHgSeTe, CdHgSTe, HgZnSeS, HgZnSeTe, HgZnSTe, and a combination thereof. The Group III-V compound may be selected from a binary element compound selected from GaN, GaP, GaAs, GaSb, AlN, AlP, AlAs, AlSb, InN, InP, InAs, InSb, and a combination thereof; a ternary element compound selected from GaNP, GaNAs, GaNSb, GaPAs, GaPSb, AlNP, AlNAs, AlNSb, AlPAs, AlPSb, InNP, InNAs, InNSb, InPAs, InPSb, and a combination thereof; and a quaternary element compound selected from GaInNSb, GaInPAs, GaInPSb, InAlNP, InAlNAs, InAlNSb, InAlPAs, InAlPSb, and a combination thereof. The Group IV-VI compound may be selected from a binary element compound selected from SnS, SnSe, SnTe, PbS, PbSe, PbTe, and a combination thereof; a ternary element compound selected from SnSeS, SnSeTe, SnSTe, PbSeS, PbSeTe, PbSTe, SnPbS, SnPbSe, SnPbTe, and a combination thereof; and a quaternary element compound selected from SnPbSSe, SnPbSeTe, SnPbSTe, and a combination thereof. In an embodiment, the Group I-III-VI compound may include $CuInSe_2$, $CuInS_2$, CuInGaSe, and CuInGaS, but are not limited thereto. In an embodiment, the Group I-II-IV-VI compound may include CuZnSnSe, and CuZnSnS, but are not limited thereto. The Group IV element or compound may be selected from a single substance selected from Si, Ge, and a combination thereof; and a binary element compound selected from SiC, SiGe, and a combination thereof. The Group III-V compound may further include a Group II metal (e.g., InZnP, etc.).

In an embodiment, the binary element compound, the ternary element compound or the quaternary element compound respectively exist in a uniform concentration in the particle or partially different concentrations in the same particle. In an embodiment, the semiconductor nanoparticle has a core-shell structure, and the semiconductor nanocrystal of the shell may have a larger energy bandgap than the semiconductor nanocrystal of the core. In an embodiment, the semiconductor nanoparticle has a core-shell structure, and the semiconductor nanocrystal of the shell may have a smaller energy bandgap than the semiconductor nanocrystal of the core. In an embodiment, the shell may be a multi-layered shell, and an outer shell layer may have a larger energy bandgap than an inner shell close to the core, but is not limited thereto. In a core-shell semiconductor nanoparticle including a multi-layered shell, an outer shell layer may have a smaller energy bandgap than a shell close to the core.

The semiconductor nanoparticle (e.g., the first semiconductor nanoparticle, the second semiconductor nanoparticle, or the third semiconductor nanoparticle) may have a size of about 1 nm to about 100 nm. In an embodiment, the semiconductor nanoparticle(s) may have a size (or an average size) of greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, or greater than or equal to about 10 nm. In an embodiment, the semiconductor nanoparticle(s) may have a size (or an average size) of less than or equal to about 50 nm, less than or equal to about 45 nm, less than or equal to about 40 nm, less than or equal to about 35 nm, less than or equal to about 30 nm, less than or equal to about 25 nm, less than or equal to about 24 nm, less than or equal to about 23 nm, less than or equal to about 22 nm, less than or equal to about 21 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, less than or equal to about 12 nm, less than or equal to about 11 nm, less than or equal to about 10 nm, less than or equal to about 9 nm, less than or equal to about 8 nm, less than or equal to about 7 nm, less than or equal to about 6.5 nm, less than or equal to about 6 nm, less than or equal to about 5.5 nm, or less than or equal to about 5 nm. In an embodiment, the size of the semiconductor nanoparticle(s) may refer to a diameter or an equivalent diameter obtained from a two-dimensional image of an electron microscopy analysis (e.g., under an assumption of a circle). In an embodiment, "a size" may refer to a size of a single semiconductor nanoparticle or a (e.g., a mean or a median) average of semiconductor nanoparticles or a population of the semiconductor nanoparticles. A size of the semiconductor nanoparticle(s) may be determined by using a result (e.g., an image) of a (transmission) electron microscopy analysis and any suitable image analysis computer program (e.g., Image J).

In an embodiment, the semiconductor nanoparticle(s) may have any shape which is not particularly limited. In an embodiment, the semiconductor nanoparticles may include spherical, pyramidal, multi-arm, or cubic nanoparticles, nanotubes, nanowires, nanofibers, nanosheets, or combinations thereof. The semiconductor nanoparticle may be commercially available or may be synthesized according to any method. In an embodiment, several nano-sized semiconductor nanoparticles may be synthesized according to a wet chemical process, for example. In an embodiment, the semiconductor nanoparticle may include an organic such as an organic solvent or an organic ligand (e.g., bound) on a surface thereof.

In an embodiment, the organic ligand having the hydrophobic moiety may include RCOOH, $RNH_2$, $R_2NH$, $R_3N$, RSH, $R_3PO$, $R_3P$, ROH, RCOOR', $RPO(OH)_2$, $R_2POOH$, where, R and R' are each independently a substituted or unsubstituted C1 to C40 (or C5 to C24) aliphatic hydrocarbon group, for example, a substituted or unsubstituted alkyl, a substituted or unsubstituted alkenyl, or a substituted or unsubstituted C3 to C40 (or C5 to C20) aromatic hydrocarbon group, for example, an aryl group, or any combinations thereof.

In an embodiment, the first color conversion region may further include a first matrix and optionally a metal oxide particle(s). The first semiconductor nanoparticles and if present the metal oxide particle(s) may be dispersed in the first matrix. In an embodiment, the second color conversion region may further include a second matrix and optionally a metal oxide particle(s). The second semiconductor nanoparticles and if present the metal oxide particle(s) may be dispersed in the second matrix.

In an embodiment, the third color conversion or light transmitting region may further include a third matrix and optionally a metal oxide particle(s). The third color conversion or light transmitting region may include or may not include semiconductor nanoparticle configured to convert the incident light into a light of a different color (e.g., the third semiconductor nanoparticles such as blue light emitting quantum dots). In the third region, the semiconductor nanoparticles, the metal oxide particle(s), or a combination thereof may be dispersed in the third matrix.

The metal oxide particle may include $TiO_2$, $SiO_2$, $BaTiO_3$, $Ba_2TiO_4$, ZnO, or a combination thereof. As used herein, the wording "metal oxide" may include an oxide of a metal or a metalloid. The metal oxide fine particle may be non-emissive. The metal oxide particle may have an appropriately selected diameter without a particular limit. The (average) diameter of the metal oxide particle(s) may be greater than or equal to about 100 nm, for example, greater than or equal to about 150 nm, or greater than or equal to about 200 nm and less than or equal to about 1000 nm or less than or equal to about 800 nm.

The metal oxide particle may be scatter and/or reflect light emitted from the semiconductor nanoparticles and/or the light emitting unit 180 of the light emitting panel 100, and thus lead the light emitted from the semiconductor nanoparticles and/or the light emitting unit 180 to an upper substrate (or, for example, a color filter layer 230a, 230b, 230c shown in FIG. 4C).

In the first color conversion region (or the second color conversion region or the third color conversion or light transmitting region), an amount of the (first, second, or third) semiconductor nanoparticle is not particularly limited and selected appropriately.

In an embodiment, in the color conversion region (e.g., the first, second, or third color conversion region), an amount of the (first, second, or third) semiconductor nanoparticles may be, based on a total weight of a composite disposed in the color conversion region (e.g., a matrix composite including semiconductor nanoparticles and optionally metal oxide particles), greater than or equal to about 1 wt%, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, greater than or equal to about 40 wt%, or greater than or equal to about 45 wt%. The amount of the (first, second, or third) semiconductor nanoparticles may be, based on a total weight of the composite disposed in the color conversion region, less than or equal to about 70 wt%, less than or equal to about 65 wt%, less than or equal to about 60 wt%, less than or equal to about 55 wt%, or less than or equal to about 50 wt%.

In an embodiment, in the color conversion region (e.g., the first, second, or third color conversion region), an amount of the metal oxide particle(s) may be, based on a total weight of the composite disposed in the color conversion region, greater than or equal to about 1 wt%, greater than or equal to about 5 wt%, or greater than or equal to about 10 wt% and less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, or less than or equal to about 5 wt%.

The matrix (e.g., the first matrix, the second matrix, the third matrix, or a combination thereof) may include a polymer. The polymer may be light transmitting. The polymer may include an insulating polymer. The polymer may include an acryl polymer (e.g., a poly(meth)acrylate, an acryl resin), an urethan polymer or resin, a silicone polymer or resin, an epoxy polymer or resin, a cardo polymer or resin, an imide polymer or resin, a derivative thereof, or a combination thereof, but is not limited thereto. The matrix may include a crosslinked polymer, a linear polymer, or a combination thereof. The cross-linked polymer may include a thiolene polymer, a cross-linked poly(meth)acrylate, a crosslinked polyurethane, a crosslinked epoxy polymer or resin, a crosslinked vinyl polymer, a crosslinked silicone polymer or resin, or a combination thereof. The linear polymer may include a repeating unit derived from carbon-carbon unsaturated bonds (e.g., a carbon-carbon double bond). The repeating unit may include a carboxylic acid group.

The linear polymer may include an ethylene repeating unit.

A first partition wall 250 may define each region (270a, 270b, 270c) of the color conversion layer 270 and be between adjacent regions. In an embodiment, the first partition wall may be disposed between adjacent color conversion regions. In an embodiment, the first partition wall 250 may respectively define the aforementioned first and second color conversion regions 270a and 270b and the third color conversion/light transmitting region 270c and may be disposed between the adjacent first and second color conversion regions 270a and 270b, between the second color conversion region 270b and the light transmitting region 270c which may be neighboring each other (e.g. adjacent to each other, or next to each other), and may be between the first color conversion region 270a and the light transmitting region 270c, which may be neighboring (e.g. adjacent to, or next to) each other in some embodiments (or would otherwise be neighboring, adjacent to, or next to each other in an embodiment where the second color conversion region 270b was omitted).

The first partition wall 250 may include a material that can prevent or block light in a given (color conversion) region from progressing into another region. In an embodiment, the first partition wall may include a material that can absorb or reflect (at least a portion of) light. In an embodiment, the first partition wall may include a light blocking or shield member. In an embodiment, the first partition wall 250 may include a material that can block, for example, absorb or reflect light. The material may include a dye, a pigment, a light reflective mat, a light absorbing material, or a combination thereof. The material is not particularly limited as long as the material can block at least a portion of a predetermined light. The material may include a material usable for a bank in a light emitting diode (e.g., OLED). In an embodiment, the pigment may be a white pigment, a black pigment, a grey pigment, or a combination thereof, but is not limited thereto. In an embodiment, the first partition wall 250 may be prepared from a photoresist composition including a pigment (e.g., a photoresist composition for preparing a black matrix, a grey matrix, or a white matrix). The photoresist composition including the pigment may be commercially available or be known in the art.

In an embodiment, referring to FIG. 4C, the color filter layer 230 may be provided, for example, between the upper substrate 210 and the color conversion layer 270. The color filter layer 230 may be positioned in a direction in which some light passing through the color conversion layer 270 may be emitted. The color filter layer 230 may include color filters 230a, 230b, and 230c in each sub-pixel $PX_1$, $PX_2$, and $PX_3$ and selectively transmit light of different wavelength spectra. The color filters 230a, 230b, and 230c may each selectively transmit light of a same wavelength spectrum as the color displayed in each sub-pixel $PX_1$, $PX_2$, and $PX_3$ and also, selectively transmit light of the emission spectrum converted in each region of the color conversion layer 270.

In an embodiment, for example, the first sub-pixel $PX_1$, the second sub-pixel $PX_2$, and the third sub-pixel $PX_3$ respectively may display green, red, and blue. In an embodiment, where light of each green emission spectrum, red emission spectrum, and blue emission spectrum may be emitted from the first color conversion region 270a, the second color conversion region 270b, and the light transmitting region 270c, respectively, the first color filter 230a overlapping the first color conversion region 270a may be a green filter, the second color filter 230b overlapping the second color conversion region 270b may be a red filter, and the third color filter 230c overlapping the light transmitting region 270c may be a blue filter. The first color filter 230a, the second color filter 230b, or the third color filter 230c may include a pigment and/or a dye to selectively transmit light of a green wavelength spectrum, a red wavelength spectrum, or a blue wavelength spectrum but absorb and/or reflect light of the other wavelength spectra.

In an embodiment, a light blocking pattern 220 may be provided between the color filter and the upper substrate. The light blocking pattern 220 may define each sub-pixel $PX_1$, $PX_2$, and $PX_3$ and be between the neighboring sub-pixels $PX_1$, $PX_2$, and $PX_3$. The light blocking pattern 220 may be, for example, a black matrix. The light blocking pattern 220 may overlap the edges of the neighboring color filters 230a, 230b, and 230c.

In an embodiment, a color conversion panel may further include a planarization layer 240, for example, disposed between the color filter layer 230 and the color conversion layer 270. The planarization layer 240 may reduce or eliminate a step difference caused by the color filter layer 230. The planarization layer 240 may include an organic material, an inorganic material, an organic-inorganic material, or a combination thereof. The planarization layer 240 may include, for example, an oxide, a nitride, and/or an oxynitride, for example, silicon oxide, silicon nitride, silicon oxynitride, or a combination thereof, but is not limited thereto. The planarization layer 240 may be one layer or two or more layers, and may cover an entire surface of the upper substrate 210.

In an embodiment, the color conversion panel may further include an encapsulation layer 290. The encapsulation layer 290 may cover the color conversion layer 270 and the partition wall 250.

The encapsulation layer 290 may include a glass plate, a metal thin film, an organic film, an inorganic film, an organic-inorganic film, or a combination thereof. The organic film may include, for example, an acrylic resin, a (meth)acrylic resin, polyisoprene, a vinyl resin, an epoxy resin, an urethane resin, a cellulose resin, a perylene resin, and/or a combination thereof, but is not limited thereto. The inorganic film may include, for example, an oxide, a nitride, and/or an oxynitride, for example silicon oxide, silicon nitride, silicon oxynitride, aluminum oxide, aluminum nitride, aluminum oxynitride, zirconium oxide, zirconium nitride, zirconium oxynitride, titanium oxide, titanium nitride, titanium oxynitride, hafnium oxide, hafnium nitride, hafnium oxynitride, tantalum oxide, tantalum nitride, tantalum oxynitride, lithium fluoride, or a combination thereof, but is not limited thereto. The organic-inorganic film may include, for example, polyorganosiloxane, but is not limited thereto. The encapsulation layer 290 may be one layer, or two, or more layers.

In the color conversion panel or the display panel according to an embodiment, an aperture ratio may be in a range of about 1 to about 100, in a range of about 20 to about 80, in a range of about 30 to about 70, in a range of about 40 to about 60, in a range of about 50 to about 55, or a combination thereof.

A small sized light emitting unit having a dimension of less than about 100 micrometers (for example, a micro LED, QNED, or the like) may be configured to emit different colors of light per a pixel, and thus may be used in a next generation display. However, a driving part of the device may have an extremely complex design in order for the small sized light emitting elements, each of which emits red light, green light, or blue light, to be adopted for each of sub-pixels, thus providing a display device having a desirably high definition would not be easy. A display device according to an embodiment may include a light emitting panel including small sized light emitting elements emitting blue (or UV) light as a light source for individual subpixels and a color conversion panel including a color conversion layer where each of color conversion regions includes first semiconductor nanoparticles (or second semiconductor nanoparticles) which emit light of a desired wavelength and thus the display device of an embodiment may achieve a display quality with a high definition even with a driving part having a relatively simple design.

In this regard, however, the inventors have also found that it may be difficult for the display panel having the above feature to have a desired level of display quality and that there may be some defects in its reliability. Without wishing to be bound by any theory, when a color conversion panel is provided with light from the small sized light emitting element, a high energy from the light source may be focused on a relatively small area of the color conversion layer, and this may result in a photo oxidation or a photo-bleaching of the semiconductor nanoparticles included therein and/or a unwanted carbonization of the matrix. Therefore, a color conversion efficiency of the color conversion layer may be significantly reduced and the display device may exhibit a low reliability as a whole.

The inventors have also found that even a 65% of light amount emitted from a given small sized light emitting unit may focused on a same area in a color conversion layer close to the given light emitting device, the photo-oxidation or the photo-bleaching of the semiconductor nanoparticles may occur or may become noticeable in that small area at which the amount of the light focused. Therefore, for example, as measured in a time resolved photoluminescent spectroscopy analysis (TRPL), the fluorescent lifetime of the semiconductor nanocrystals in the color conversion region may decrease.

In addition, the inventors have found that at the small, light-focused area in the color conversion region, the carbonization of the polymer in the matrix progress, and this can further undermine the reliability of the device as a whole.

In the display device according to an embodiment, the aforementioned drawbacks are addressed and thus the device may exhibit a desired level of reliability even with the small sized light source, realizing improved display qualities in terms of a luminance, an efficiency, or a viewing angle and high definition.

According to such an embodiment, the display device includes a first optical diffuser disposed between the first light emitting unit and the first color conversion region to cover the light extraction surface of the first light emitting unit, and/or the display device includes a second optical diffuser disposed between the second light emitting unit and the second color conversion region to cover the light extraction surface of the second light emitting unit, wherein the first optical diffuser and the second optical diffuser are (e.g., physically, optically, or physically and optically) spaced apart with each other. In an embodiment, the optical diffuser "covering the light extraction surface" may be the case where the optical diffuser overlaps most (for example, greater than or equal to about 90%, greater than or equal to about 95%, greater than or equal to about 99%, or about 100%) of the area of the light extraction surface. In an embodiment, the first optical diffuser and the second optical diffuser may be physically or optically isolated with each other. In an embodiment, the display panel may include the first optical diffuser and/or second optical diffuser, each of which is patterned, for example, corresponding to the light emitting unit or the color conversion region.

In an embodiment, the display device may further include a third optical diffuser between the third light emitting unit and the third color conversion/ light transmitting region, and the third optical diffuser may cover the light extraction surface of the third light emitting unit.

In the display panel according to an embodiment, as measured in a cross-section of the panel, a length of the (first, second, or third) optical diffuser may be substantially longer than the length of the (first, second, or third) light extraction surface of the light emitting unit.

In an embodiment, as measured in a cross-section of the display panel, a ratio of the length (L12, L22, L32) of the (first, second, or third) optical diffuser to the length (L11, L21, L31) of the light extraction surface of the (first, second, or the third) light emitting unit may be greater than or equal to about 1:1, greater than about 1.05:1, greater than or equal to about 1.1:1, greater than or equal to about 1.2:1, greater than or equal to about 1.3:1, greater than or equal to about 1.4:1, greater than or equal to about 1.5:1, greater than or equal to about 1.7:1, greater than or equal to about 1.9:1, greater than or equal to about 2:1, greater than or equal to about 4:1, greater than or equal to about 6:1, greater than or equal to about 8:1, greater than or equal to about 10:1, greater than or equal to about 12:1, greater than or equal to about 14:1, greater than or equal to about 16:1, greater than or equal to about 18:1, greater than or equal to about 20:1, greater than or equal to about 22:1, greater than or equal to about 24:1, greater than or equal to about 26:1, or greater than or equal to about 28:1. In an embodiment, as measured in a cross-section of the display panel, a ratio of the length (L12, L22, L32) of the (first, second, or third) optical diffuser to the length (L11, L21, L31) of the light extraction surface of the (first, second, or the third) light emitting unit may be less than or equal to about 60:1, less than or equal to about 50:1, less than or equal to about 45:1, less than or equal to about 40:1, less than or equal to about 35:1, less than or equal to about 30:1, less than or equal to about 25:1, less than or equal to about 20:1, less than or equal to about 18:1, less than or equal to about 16:1, less than or equal to about 15:1, less than or equal to about 13:1, less than or equal to about 11:1, less than or equal to about 9:1, less than or equal to about 7:1, less than or equal to about 5:1, or less than or equal to about 3:1. In an embodiment, the length of the optical diffuser may be a length of a longest straight line crossing a cross-section thereof and substantially parallel to a bottom of the panel or the light extraction surface. The light extraction surface may substantially parallel to the bottom of the panel, but is not limited thereto. The light extraction surface may be substantially perpendicular to a light progressing direction (z-axis direction), but is not limited.

In an embodiment, as measured in a cross-section of the display panel, a ratio of the length (L12, L22, L32) of the (first, second, or third) optical diffuser to the length (L13, L23, L33) of the (first color conversion, second color conversion, or third color conversion/light transmitting) region may be greater than or equal to about 0.1:1 and less than or equal to about 1.2:1.

In an embodiment, as measured in a cross-section of the display panel, a ratio of the length (L12, L22, L32) of the (first, second, or third) optical diffuser to the length (L13, L23, L33) of the (first color conversion, second color conversion, or third color conversion/light transmitting) region may be in a range of about 0.1 to about 1.2, in a range of about 0.1 to about 1.1, in a range of about 0.15 to about 1.1, in a range of about 0.2 to about 0.8, in a range of about 0.2 to about 1.0, in a range of about 0.25 to about 0.95, in a range of about 0.3 to about 0.7, in a range of about 0.3 to about 0.9, in a range of about 0.35 to about 0.85, in a range of about 0.4 to about 0.8, in a range of about 0.45 to about 0.75, in a range of about 0.5 to about 0.7, or a combination thereof.

In an embodiment, as determined in a cross-section of the display panel, a (cross-sectional) shape of the optical diffuser is not particularly limited and may have any shape. The cross-section of the optical diffuser may be a square, a rectangle, an oval, a half-moon shape, or a combination thereof, but is not limited thereto.

In an embodiment, a second partition wall may be disposed between the optical diffusers (e.g., between the first optical diffuser and the second optical diffuser). The first partition wall and the second partition wall may be (e.g., may form) an integrated structure (e.g., integrally formed with each other as a single unitary and indivisible body). Other features of the second partition wall may be the same as those of the first partition wall.

In an embodiment, the first optical diffuser, the second optical diffuser, (if present, the third optical diffuser) or a combination thereof may include inorganic particles (e.g., metal oxide particles) dispersed in a matrix. The inorganic particles may include a zinc oxide, a titanium oxide, a zirconium oxide, a silicon oxide, a barium oxide, an aluminum oxide, or a combination thereof. The inorganic particles or the metal oxide particles may include $TiO_2$, $SiO_2$, $BaTiO_3$, $Ba_2TiO_4$, $ZnO$, $Al_2O_3$, or a combination thereof.

The inorganic particle(s) or the metal oxide particle(s) may have a size (or an average size) of greater than about 70 nm. The size (or the average size) of the inorganic particle(s) or the metal oxide particle(s) may be in a range of greater than about 70 nm to less than or equal to about 700 nm, in a range of about 75 nm to about 750 nm, in a range of about 80 nm to about 700 nm, in a range of about 90 nm to about 650 nm, in a range of about 100 nm to about 600 nm, in a range of about 110 nm to about 550 nm, in a range of about 120 nm to about 500 nm, in a range of about 130 nm to about 450 nm, in a range of about 140 nm to about 400 nm, in a range of about 150 nm to about 350 nm, in a range of about 200 nm to about 300 nm, or a combination thereof.

In an embodiment, in the first optical diffuser (or the second optical diffuser, or the third optical diffuser), for example, as measured in a thermogravimetric analysis, an amount of inorganics may be, based on a total weight of the first optical diffuser (or the second optical diffuser, or the third optical diffuser), greater than or equal to about 0.5 wt%, greater than or equal to about 1 wt%, or greater than or equal to about 5 wt%, and less than or equal to about 60 wt%, less than or equal to about 50 wt%, less than or equal to about 45 wt%, less than or equal to about 40 wt%, less than or equal to about 35 wt%, less than or equal to about 30 wt%, less than or equal to about 25 wt%, less than or equal to about 20 wt%, or less than or equal to about 15 wt%.

The optical diffuser may not include a semiconductor nanoparticle such as a quantum dot that can convert (change) emission spectrum of light into different spectrum.

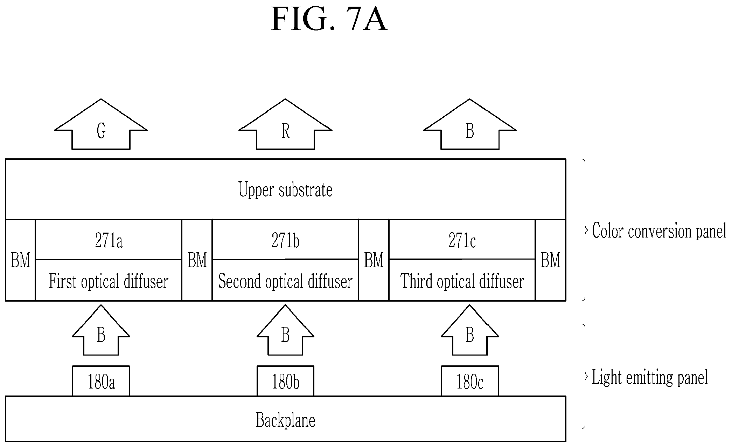

The arrangement of the optical diffusers will hereinafter be described in greater detail with reference to FIG. 7A to FIG. 7D.

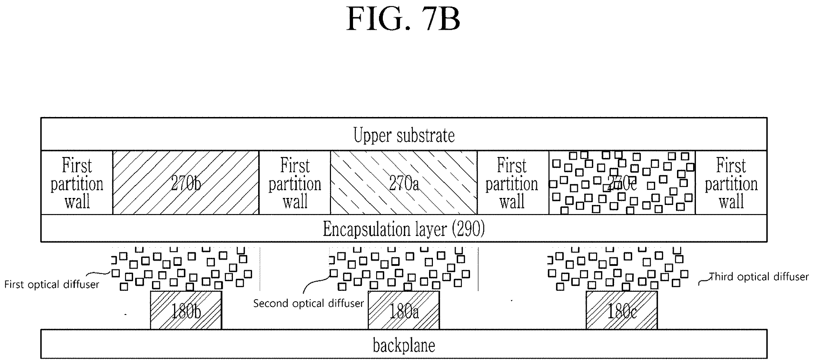

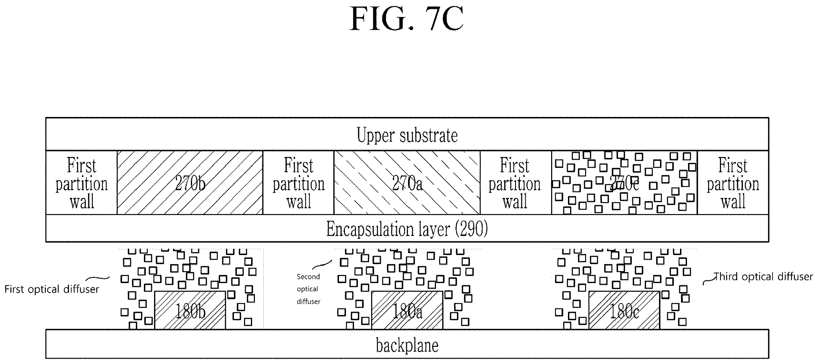

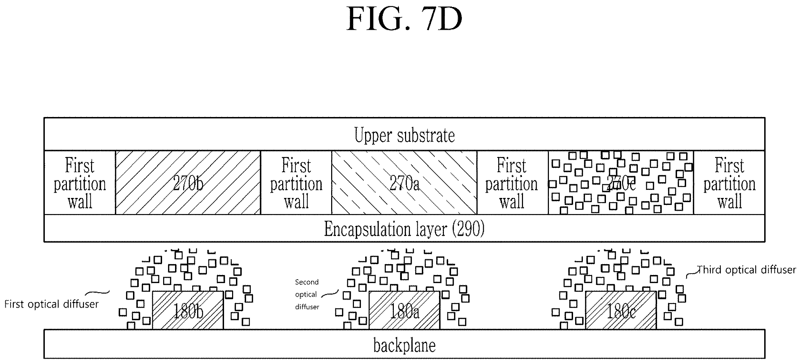

FIG. 7A is a cross-sectional view illustrating a display panel according to an embodiment, FIG. 7B is a cross-sectional view illustrating a display panel according to an embodiment, FIG. 7C is a cross-sectional view illustrating a display panel according to an embodiment, and FIG. 7D is a cross-sectional view illustrating a display panel according to an embodiment.

Referring to FIG. 7A, in an embodiment, the first optical diffuser (or the second optical diffuser or the third optical diffuser) may be disposed adjacent to (or directly contacting to) the first color conversion region (or the second color conversion region or the third color conversion/light transmitting region). In an embodiment, an additional element may be or may not be disposed between the first optical diffuser (or the second optical diffuser or the third optical diffuser) and the first color conversion region (or the second color conversion region or the third color conversion/light transmitting region).

In an embodiment, a light transmitting layer 300 may be disposed (e.g., inserted) between the light emitting panel 100 and the color conversion panel 200. In an embodiment, a display panel may include a light transmitting layer or a light transmitting region between the first optical diffuser (or the second optical diffuser or the third optical diffuser) and the first light emitting unit (or the second light emitting unit or the third light emitting unit). In an embodiment, the light transmitting layer 300 may include (or may be) a filling material and may include an organic material, an inorganic material, an organic-inorganic hybrid material, or a combination thereof. The light transmitting layer 300 or the filling material may include an epoxy resin or polymer, a silicon compound, a polyorganosiloxane, or a combination thereof, is not limited thereto.

Referring to FIG 7B, the display panel according to an embodiment may further include an optical auxiliary layer, a predetermined optical path, an encapsulation layer, or a combination thereof between the first color conversion region (or the second color conversion region or the third color conversion/light transmitting region) and the first optical diffuser (or the second optical diffuser or the third optical diffuser). The optical auxiliary layer may include a light transmitting layer, an optical recycling layer (e.g., a yellow recycling layer), or a combination thereof, but is not limited thereto.

Referring to FIG. 7C and FIG. 7D, in an alternative embodiment, the first optical diffuser (or the second optical diffuser or the third optical diffuser) may be disposed on (e.g., directly on) the first light emitting unit (or the second light emitting unit or the third light emitting unit).

In an embodiment, the first optical diffuser, the second optical diffuser, or the third optical diffuser may have each independently a height (H12, H22, H32) of greater than or equal to about 100 nm, greater than or equal to about 200 nm, greater than or equal to about 300 nm, greater than or equal to about 400 nm, greater than or equal to about 500 nm, greater than or equal to about 600 nm, greater than or equal to about 700 nm, greater than or equal to about 800 nm, greater than or equal to about 900 nm, greater than or equal to about 1 $\mu$m, greater than or equal to about 1.5 $\mu$m, greater than

or equal to about 2 $\mu$m, greater than or equal to about 2.5 $\mu$m, or greater than or equal to about 3 $\mu$m. In an embodiment, the first optical diffuser, the second optical diffuser, or the third optical diffuser may have each independently a height (H12, H22, H32) of less than or equal to about 100 $\mu$m, less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 15 $\mu$m, less than or equal to about 10 $\mu$m, less than or equal to about 9 $\mu$m, less than or equal to about 8 $\mu$m, less than or equal to about 7 $\mu$m, less than or equal to about 6 $\mu$m, less than or equal to about 5 $\mu$m, less than or equal to about 4 $\mu$m, less than or equal to about 3.5 $\mu$m, less than or equal to about 3 $\mu$m, less than or equal to about 2.5 $\mu$m, less than or equal to about 2 $\mu$m, less than or equal to about 900 nm, less than or equal to about 800 nm, less than or equal to about 700 nm, less than or equal to about 600 nm, or less than or equal to about 500 nm.

In an embodiment, an area of a light extracting surface of the first optical diffuser (or the second optical diffuser, or the third optical diffuser) (e.g., an area of its surface facing the color conversion region) may be at least 2 times, at least 3 times, at least 4 times, at least 5 times, at least 6 times, at least 7 times, at least 8 times, at least 9 times, at least 10 times of an area of the light extraction surface of the first light emitting unit (or the second light emitting unit or the third light emitting unit). The area of a light extracting surface of the first optical diffuser (or the second optical diffuser, or the third optical diffuser) (e.g., an area of its surface facing the color conversion region) may be, 200 times, at most 170 times, at most 150 times, at most 130 times, at most 100 times, at most 90 times, at most 80 times, at most 70 times, at most 60 times, at most 50 times, at most 40 times, at most 30 times, at most 20 times, or at most 15 times of an area of the light extraction surface of the first light emitting unit (or the second light emitting unit or the third light emitting unit).

In the display panel according to an embodiment, the optical diffuser may be an optical element that diffuses or scatters at least a portion (or the entire) of light emitted from the light emitting unit prior to being entered into the color conversion layer (region). In an embodiment of the invention, as described herein, the light emitted from light emitting unit and entering the color conversion layer may be relatively uniformly dispersed at an incident surface of the color conversion layer by the optical diffuser, thereby minimizing the occurrence of high intensity bright spot. In an embodiment, the optical diffuser may include or may be a scattering body. Without wishing to be bound by any theory, in a display device according to an embodiment, as the light emitted from the light emitting unit enters the optical diffuser, multiple scattering may occur and thus the light path in the diffuser may change randomly and the randomness of interaction may be averaged out in the optical diffuser. Therefore, without any substantial loss of light amount, the third light passing through the optical diffuser may enter uniformly a wider area of the color conversion layer.

In an embodiment, a ratio of a luminance (cd/m$^2$) of light entering the first color conversion region (or the second color conversion region or the third color conversion region) to a luminance of light emitted from the first light emitting unit (or the second light emitting unit or the third light emitting unit may be greater than or equal to about 0.05:1, greater than or equal to about 0.08:1, greater than or equal to about 0.1:1, greater than or equal to about 0.25:1, greater than or equal to about 0.3:1, greater than or equal to about 0.35:1, or greater than or equal to about 0.5:1.

In an embodiment, a ratio of a luminance (cd/m$^2$) of light entering the first color conversion region (or the second color conversion region or the third color conversion region) to a luminance of light emitted from the first light emitting unit (or the second light emitting unit or the third light emitting unit may be, less than or equal to about 0.95:1, less than or equal to about 0.8:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.4:1, or less than or equal to about 0.35:1.

A luminance deviation in a light entering surface of the first color conversion region (or the second color conversion region or the third color conversion region, or all of them) may be less than or equal to about 30%. The luminance deviation may be defined as below:

$$(L_{max} - L_{min})/L_{max,}$$

where, $L_{max}$ denotes the highest luminance measured in a given light entering surface, and $L_{min}$ denotes the lowest luminance measured in a given light entering surface.

In an embodiment, the display panel may be prepared in any suitable manner. According to an embodiment, the display panel may be prepared by a process including: providing a light emitting panel; providing a color conversion panel; and assembling the light emitting panel and the color conversion panel to prepare the display panel, wherein the light emitting panel or the color conversion panel includes the optical diffuser.

In an embodiment, the process of providing the color conversion panel may include providing a substrate; providing a partition wall on the substrate; depositing a composition (e.g., an ink composition) including semiconductor nanoparticles into a region defined by the partition wall; optionally carrying out a polymerization of the composition, but is not limited thereto. In an embodiment, the process of providing the color conversion panel may include a photolithography process using a photosensitive composition including semiconductor nanoparticles. In the photolithography process, the photosensitive composition may be applied (or coated) on a substrate to form a film, which is then optionally prebaked, exposed to light under a mask having a pattern, developed with a developing liquid (e.g., an alkaline aqueous solution), and optionally post-baked to form a semiconductor nanoparticle - polymer composite pattern, but the process is not limited thereto.

In an embodiment, the providing of the color conversion panel may involve an electrohydrodynamic (EHD) patterning. In the EHD patterning, a relatively strong electric filed may be applied between a nozzle and a lower electrode to form a fine liquid drop, which may be applied for patterning a composition including semiconductor nanoparticles.

In an embodiment, providing the light emitting panel may vary with a type of the light emitting panel to be provided (e.g., QNED or micro-LED), and may be prepared in any suitable method.

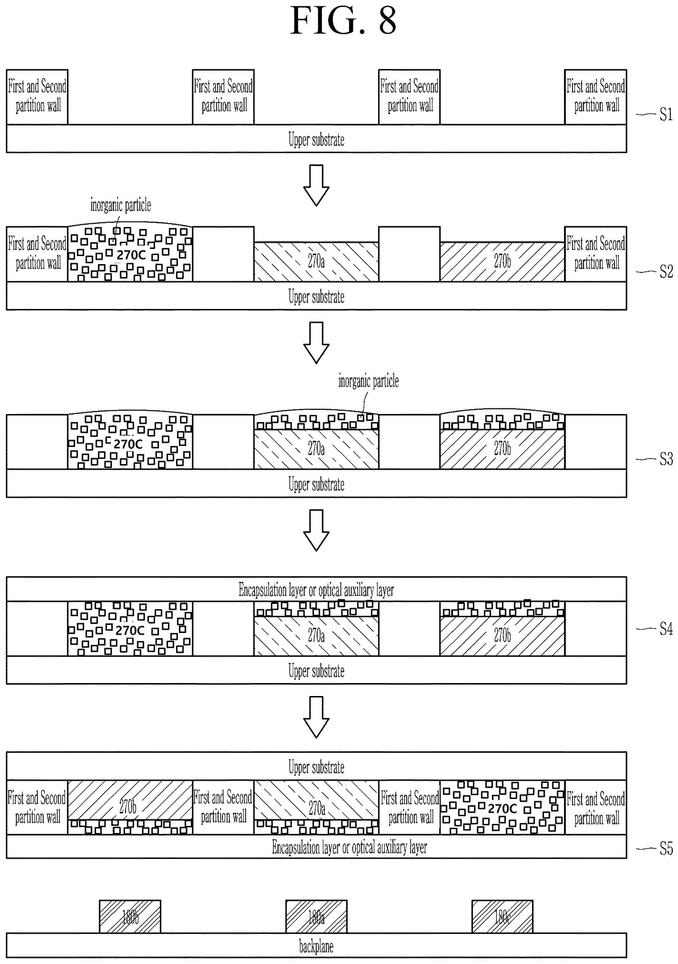

In an embodiment, providing the optical diffuser (for example, as shown in FIG. 7B, FIG. 7C, and FIG. 7D) may include preparing a composition for the optical diffuser (e.g., a composition including inorganic particles or metal oxide particles together with a resin or monomer or a polymer), depositing the composition on each of the light emitting units in the light emitting panel, and optionally carrying out a polymerization. In an embodiment, providing the optical diffuser (for example, as shown in FIG. 7A) may include preparing a substrate provided with a partition wall (S1), forming a color conversion layer including the partition wall and a color conversion region (S2); forming a first optical diffuser and a second optical diffuser in the first color conversion region and the second color conversion region (S3), respectively; optionally forming an optical auxiliary layer (S4); and assembling the light emitting panel and the color conversion panel (S5) (see FIG. 8)

The formation of the optical diffuser may be conducted using the composition for the optical diffuser. The formation of the optical diffuser may be carried out by using an ink jet printing manner, a photolithography process, an electrohydrodynamic spinning, or the like, but is not limited thereto.

Embodiments of the display panel described herein may be included in various electronic devices (for example, a display device such as TV, a monitor, a computer, a tablet PC, a mobile device, or the like or a lighting device). In an embodiment, an electronic device includes the display panel. The electronic device may include a portable terminal device, a monitor, a notebook PC, a television, an electronic display, a camera, an electronic part for an automobile, or a combination thereof.

Hereinafter, the embodiments will be described in greater detail with reference to examples. However, they are merely examples of embodiments of the disclosure, and the disclosure is not limited thereto.

Experimental Examples

A green quantum dot film including green light emitting quantum dots dispersed in a polymer and a red quantum dot film including red light emitting quantum dots dispersed in a polymer were prepared. Blue light of a wavelength of 450 nm having a luminance of 450,000 nit or 225,000 nit was radiated to each of the quantum dot film and a luminance of light emitted from each of the quantum dot film was observed over time.

A time it takes for the luminance of the quantum dot film to decrease to 90% of the initial value (100%) thereof is measured. The results confirm that in case of the green quantum dot film, the T90 measured upon the radiation of the incident light of 225,000 nit is 14.3 times greater than the T90 measured upon the radiation of the incident light of 450,000 nit, and in case of the red quantum dot film, the T90 measured upon the radiation of the incident light of 225,000 nit is 46.5 times greater than the T90 measured upon the radiation of the incident light of 450,000 nit.

A time resolved photoluminescent spectroscopy analysis was conducted for each of the green quantum dot film and the red quantum dot film using a time correlated single photon counting (TCSPC) after 90 hours radiation of the 450,000 nit of Blue LED. According to the results, the quantum dots in the film was undergone the photo-bleaching and the polymer in the film showed the carbonization, and the fluorescent life time of the quantum dots included therein was changed.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

**Claims**

1. A display panel, comprising

   a light emitting panel comprising a plurality of light emitting units; and
   a color conversion panel including a surface opposite a surface of the light emitting panel,
   wherein the plurality of light emitting units comprises a first light emitting unit and a second light emitting unit,
   the color conversion panel comprises a color conversion layer comprising a first color conversion region and a second color conversion region, and a first partition wall defining the first color conversion region and the second color conversion region,
   the first color conversion region comprises first semiconductor nanoparticles, wherein the first color conversion region is configured to convert a third light emitted from the first light emitting unit to a first light,
   the second color conversion region comprises second semiconductor nanoparticles, wherein the second color conversion region is configured to convert a third light emitted from the second light emitting unit to a second light,
   wherein a first optical diffuser is disposed between the first light emitting unit and the first color conversion region to cover a light extraction surface of the first light emitting unit,
   wherein a second optical diffuser is disposed between the second light emitting unit and the second color conversion region to cover a light extraction surface of the second light emitting unit,
   wherein the first optical diffuser and the second optical diffuser are spaced apart from one another,
   wherein, in a cross-section of the display panel, a length of the light extraction surface of the first light emitting unit is greater than or equal to 500 nm and less than or equal to 100 $\mu$m and a ratio of a length of the first optical diffuser to the length of the light extraction surface of the first light emitting unit is greater than or equal to 1.4:1 and less than or equal to 60:1,
   a length of the light extraction surface of the second light emitting unit is greater than or equal to 500 nm and less than or equal to 100 $\mu$m and a ratio of a length of the second optical diffuser to the length of the light extraction surface of the second light emitting unit is greater than or equal to 1.4:1 and less than or equal to 60:1.

2. The display panel of claim 1, wherein the light emitting panel comprises a micro light emitting diode, an inorganic nano light emitting diode, or a combination thereof, and/or

   wherein the first light emitting unit and the second light emitting unit are spaced apart from one another, and
   optionally wherein a partition wall is disposed between the first light emitting unit and the second light emitting unit.

3. The display panel of either claim 1 or claim 2, wherein a luminescent peak wavelength of the first light is in a range of greater than or equal to 500 nm and less than or equal to 580 nm, and/or

   a luminescent peak wavelength of the second light is in a range of greater than 580 nm and less than or equal to 680 nm and/or a luminescent peak wavelength of the third light is greater than or equal to about 360nm and less than about 500nm.

4. The display panel of any one of the preceding claims, wherein the first color conversion region comprises a first matrix and optionally metal oxide particles, and the first semiconductor nanoparticles and optionally the metal oxide particles are dispersed in the first matrix, or wherein the second color conversion region further comprises a second matrix and optionally metal oxide particles, and the second semiconductor nanoparticles optionally the metal oxide particles are dispersed in the second matrix.

5. The display panel of any one of the preceding claims, wherein in the cross-section of the display panel,

the length of the first optical diffuser is greater than or equal to 0.1 times and less than or equal to 1.2 times a length of the first color conversion region, and
the length of the second optical diffuser is greater than or equal to 0.1 times and less than or equal to 1.2 times a length of the second color conversion region.

6. The display panel of any one of the preceding claims, wherein a length of the first color conversion region and a length of the second color conversion region are each independently greater than or equal to 1 $\mu$m, and less than or equal to 700 $\mu$m.

7. The display panel of any one of the preceding claims, wherein a second partition wall is disposed between the first optical diffuser and the second optical diffuser and optionally wherein the first partition wall and the second partition wall are an integrated structure.

8. The display panel of any one of the preceding claims, wherein the first optical diffuser or the second optical diffuser comprises metal oxide particles dispersed in a matrix and optionally wherein the metal oxide particles comprise a zinc oxide, a titanium oxide, a zirconium oxide, a silicon oxide, a barium oxide, an aluminum oxide, or a combination thereof, and/or optionally wherein an average size of the metal oxide particles is greater than 70 nm and less than or equal to 700 nm.

9. The display panel of any one of the preceding claims, wherein the first optical diffuser is disposed adjacent to the first color conversion region, and/or

wherein the second optical diffuser is disposed adjacent to the second color conversion region; and/or wherein the first optical diffuser is disposed adjacent to the first light emitting unit, and/or wherein the second optical diffuser is disposed adjacent to the second light emitting unit.

10. The display panel of any one of the preceding claims, wherein the display panel further comprises an optical auxiliary layer between the first color conversion region and the first optical diffuser or between the second color conversion region and the second optical diffuser.

11. The display panel of claim 1, wherein the first optical diffuser or the second optical diffuser has each independently a height of greater than or equal to 100 nm and less than or equal to 10 $\mu$m.

12. The display panel of any one of the preceding claims, wherein an area of a light extraction surface of the first optical diffuser is greater than or equal to 2 times and less than or equal to 200 times an area of the light extraction surface of the first light emitting unit, and/or

wherein an area of a light extraction surface of the second optical diffuser is greater than or equal to 2 times and less than or equal to 200 times an area of the light extraction surface of the second light emitting unit.
wherein the light emitting panel comprises a micro light emitting diode, an inorganic nano light emitting diode, or a combination thereof.

13. The display panel of any one of the preceding claims, wherein a luminance ratio of light entering the first color conversion region with respect to light emitted from the first light emitting unit is greater than or equal to 0.05:1 and less than or equal to 0.95:1, and/or wherein a luminance ratio of light entering the second color conversion region with respect to light emitted from the second light emitting unit is greater than or equal to 0.05:1 and less than or equal to 0.95:1.

14. The display panel of any one of the preceding claims, wherein a light entering surface of the first color conversion region or a light entering surface of the second color conversion region is configured to exhibit a luminance deviation of an incident light of less than or equal to 30%.

15. An electronic device comprising the display panel of any one of the preceding claims.

# FIG. 1A

1000

200
400
100

z
y ⊗ → x

FIG. 1B

# FIG. 2

1000

200

400

100

300

z

y⊗ →x

# FIG. 3

1000

PX

PX₁ PX₂ PX₃

IV    IV

. . .

1000D

1000P

. . .

. . . .

. . . .

. . .

y

z⊙ →x

# FIG. 4A

First partition wall     First partition wall

Upper substrate ⎫ Color conversion panel
Color conversion layer ⎭

H13 — First color conversion region — L13

H23 — Second color conversion region — L23

H33 — Third color conversion region — L33

H12 First optical diffuser — L12

H22 Second optical diffuser — L22

H32 Third optical diffuser — L32

Light extraction face — L11

Light extraction face — L21

Light extraction face — L31

First light emitting unit 180A

Partition Wall

Second light emitting unit 180B

Partition Wall

Third light emitting unit 180C

Front Plane

Backplane (including a lower substrate and a circuit element)

Light emitting panel

light progress direction

z
y ⊗ → x

PX 1          PX 2          PX 3

EP 4 125 128 A1

# FIG. 4B

EP 4 125 128 A1

# FIG. 4C

# FIG. 5

180

| | |
|---|---|
| | ~182 |
| | ~185 |
| | ~183 |
| | ~184 |
| | ~181 |

z
y⊗ →X

# FIG. 6

# FIG. 7A

# FIG. 7B

Upper substrate

| First partition wall | 270b | First partition wall | 270a | First partition wall | 270c | First partition wall |

Encapsulation layer (290)

First optical diffuser

Second optical diffuser

Third optical diffuser

180b          180a          180c

backplane

# FIG. 7C

| Upper substrate | | | | | | |
|---|---|---|---|---|---|---|
| First partition wall | 270b | First partition wall | 270a | First partition wall | 270c | First partition wall |
| Encapsulation layer (290) | | | | | | |

First optical diffuser

Second optical diffuser

180b

180a

180c

Third optical diffuser

backplane

EP 4 125 128 A1

# FIG. 7D

Upper substrate

| First partition wall | 270b | First partition wall | 270a | First partition wall | 270c | First partition wall |

Encapsulation layer (290)

First optical diffuser · Second optical diffuser · Third optical diffuser

180b · 180a · 180c

backplane

# FIG. 8

# EP 4 125 128 A1

Europäisches
Patentamt

European
Patent Office

Office européen
des brevets

# EUROPEAN SEARCH REPORT

**Application Number**

EP 22 18 7251

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/028327 A1 (LIN HSIAO-LANG [TW] ET AL) 28 January 2021 (2021-01-28) * paragraphs [0025] – [0082]; figures 4,5,6,7 * ----- | 1-15 | INV. H01L25/075 H01L33/50 H01L33/58 |
| X | US 2021/074769 A1 (PARK SANG JIN [KR] ET AL) 11 March 2021 (2021-03-11) * paragraphs [0044] – [0357]; figure 23 * ----- | 1-15 | ADD. H01L27/32 |
| A | US 2019/385513 A1 (IGUCHI KATSUJI [JP] ET AL) 19 December 2019 (2019-12-19) * paragraphs [0191] – [0259]; figure 23 * ----- | 1-15 | |

**TECHNICAL FIELDS SEARCHED (IPC)**

H01L

The present search report has been drawn up for all claims

| Place of search | Date of completion of the search | Examiner |
|---|---|---|
| The Hague | 8 December 2022 | Simeonov, Dobri |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 125 128 A1**

## ANNEX TO THE EUROPEAN SEARCH REPORT
## ON EUROPEAN PATENT APPLICATION NO.

EP 22 18 7251

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2022

| Patent document cited in search report | | Publication date | Patent family member(s) | | Publication date |
|---|---|---|---|---|---|
| US 2021028327 | A1 | 28-01-2021 | CN | 112310300 A | 02-02-2021 |
| | | | PH | 12020050229 A1 | 10-01-2022 |
| | | | US | 2021028327 A1 | 28-01-2021 |
| US 2021074769 | A1 | 11-03-2021 | CN | 112490385 A | 12-03-2021 |
| | | | EP | 3792978 A1 | 17-03-2021 |
| | | | KR | 20210031586 A | 22-03-2021 |
| | | | US | 2021074769 A1 | 11-03-2021 |
| US 2019385513 | A1 | 19-12-2019 | CN | 110100318 A | 06-08-2019 |
| | | | CN | 114695425 A | 01-07-2022 |
| | | | JP | 6740374 B2 | 12-08-2020 |
| | | | JP | 7033172 B2 | 09-03-2022 |
| | | | JP | 2020191460 A | 26-11-2020 |
| | | | JP | WO2018116814 A1 | 24-10-2019 |
| | | | US | 2019385513 A1 | 19-12-2019 |
| | | | US | 2021150978 A1 | 20-05-2021 |
| | | | WO | 2018116814 A1 | 28-06-2018 |

EPO FORM P0459

For more details about this annex : see Official Journal of the European Patent Office, No. 12/82